(19) Europäisches Patentamt / European Patent Office / Office européen des brevets

(11) **EP 4 073 475 B1**

(12) **EUROPÄISCHE PATENTSCHRIFT**

(45) Veröffentlichungstag und Bekanntmachung des Hinweises auf die Patenterteilung:
**15.11.2023   Patentblatt 2023/46**

(21) Anmeldenummer: **20811305.0**

(22) Anmeldetag: **20.11.2020**

(51) Internationale Patentklassifikation (IPC):
**G01F 1/84** *(2006.01)*      **G01F 15/02** *(2006.01)*
**G01F 25/10** *(2022.01)*      **G01F 15/00** *(2006.01)*

(52) Gemeinsame Patentklassifikation (CPC):
**G01F 1/8427; G01F 1/8436; G01F 15/02;**
**G01F 25/10;** G01F 15/007

(86) Internationale Anmeldenummer:
**PCT/EP2020/082907**

(87) Internationale Veröffentlichungsnummer:
**WO 2021/115761 (17.06.2021 Gazette 2021/24)**

(54) **VIBRONISCHES MESSSYSTEM ZUM MESSEN EINES MASSESTROMS EINES FLUIDEN MESSSTOFF UND VERWENDUNG DES VIBRONISCHEN MESSSYSTEMS**

VIBRONIC MEASURING SYSTEM FOR MEASURING A MASS FLOW RATE OF A FLUID MEASUREMENT MEDIUM AND USE OF THE VIBRONIC MEASURING DEVICE

SYSTÈME DE MESURE VIBRONIQUE DESTINÉ À MESURER UN DÉBIT MASSIQUE D'UN MILIEU DE MESURE FLUIDE ET UTILISATION DU SYSTÈME DE MESURE VIBRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.12.2019   DE 102019133610**

(43) Veröffentlichungstag der Anmeldung:
**19.10.2022   Patentblatt 2022/42**

(73) Patentinhaber: **Endress + Hauser Flowtec AG**
**4153 Reinach (CH)**

(72) Erfinder:
• **RIEDER, Alfred**
  **84032 Landshut (DE)**
• **LALLA, Robert**
  **79541 Lörrach (DE)**
• **BRAUN, Marcel**
  **79594 Inzlingen (DE)**
• **BITTO, Ennio**
  **4147 Aesch (CH)**
• **POHL, Johan**
  **79110 Freiburg (DE)**

(74) Vertreter: **Hahn, Christian**
**Endress+Hauser Group Services**
**(Deutschland)AG +Co. KG**
**Colmarer Straße 6**
**79576 Weil am Rhein (DE)**

(56) Entgegenhaltungen:
EP-A1- 0 644 403          WO-A1-88/03642
WO-A1-93/13391          WO-A1-97/26508
DE-A1-102007 062 397     DE-A1-102008 044 186

**Beschreibung**

Die Erfindung betrifft ein vibronisches Meßsystem, insb. ein Coriolis-Massedurchfluß-Meßgerät, zum Messen eines Massestroms eines fluiden Meßstoff.

In der industriellen Meßtechnik werden - insb. auch im Zusammenhang mit der Regelung und Überwachung von automatisierten verfahrenstechnischen Prozessen - zur hochgenauen Ermittlung einer oder mehrerer Meßgrößen, beispielsweise eines Massestroms und/oder einer Dichte, eines in einer Prozeßleitung, beispielsweise einer Rohrleitung, strömenden Meßstoffs, beispielsweise einer Flüssigkeiten, eines Gases oder einer Dispersion, oftmals jeweils mittels einer - zumeist mittels wenigstens eines Mikroprozessors gebildeten Meßelektronik - sowie einem mit nämlicher Meßsystem-Elektronik elektrisch verbundenen, im Betrieb vom zu messenden Meßstoff durchströmten Meßaufnehmer vom Vibrationstyp gebildeten vibronischen Meßsyteme verwendet. Beispiele für solche, beispielsweise auch als Coriolis-Massedurchfluß-Meßgeräte, Coriolis-Massedurchfluß-Dichte-Meßgeräte und/oder Coriolis-Massedurchfluß-Viskositäts-Meßgeräte, ausgebildeten Meßsysteme sind u.a. in der EP-A 564 682, EP-A 816 807, EP-A 644 403, der US-A 2002/0033043 der US-A 2006/0096390, der US-A 2007/0062309, der US-A 2007/0119264, der US-A 2008/0011101, der US-A 2008/0047362, der US-A 2008/0190195, der US-A 2008/0250871, der US-A 2010/0005887, der US-A 2010/0011882, der US-A 2010/0257943, der US-A 2011/0161017, der US-A 2011/0178738, der US-A 2011/0219872, der US-A 2011/0265580, der US-A 2011/0271756, der US-A 2012/0123705, der US-A 2013/0042700, der US-A 2016/0071639, der US-A 2016/0313162, der US-A 2016/0187176, der US-A 2017/0003156, der US-A 2017/0261474, der US-A 44 91 009, der US-A 47 56 198, der US-A 47 77 833, der US-A 48 01 897, der US-A 48 76 898, der US-A 49 96 871, der US-A 5009 109, der US-A 52 87 754, der US-A 52 91 792, der US-A 53 49 872, der US-A 57 05 754, der US-A 57 96 010, der US-A 57 96 011, der US-A 58 04 742, der US-A 58 31 178, der US-A 59 45 609, der US-A 59 65 824, der US-A 60 06 609, der US-A 60 92 429, der US-B 62 23 605, der US-B 63 11 136, der US-B 64 77 901, der US-B 65 05 518, der US-B 65 13 393, der US-B 66 51 513, der US-B 66 66 098, der US-B 67 11 958, der US-B 68 40 109, der US-B 68 83 387, der US-B 69 20 798, der US-B 70 17 424, der US-B 70 40 181, der US-B 70 77 014, der US-B 71 43 655, der US-B 72 00 503, der US-B 72 16 549, der US-B 72 96 484, der US-B 73 25 462, der US-B 73 60 451, der US-B 76 65 369, der US-B 77 92 646, der US-B 79 54 388, der US-B 82 01 460, der US-B 83 33 120, der US-B 86 95 436, der WO-A 00/19175, der WO-A 00/34748, der WO-A 01/02812, der WO-A 01/02816, der WO-A 01/71291, der WO-A 02/060805, der WO-A 2005/050145, der WO-A 2005/093381, der WO-A 2007/043996, der WO-A 2008/013545, der WO-A 2008/059262, der WO-A 2009/148451, der WO-A 2010/099276, der WO-A 2013/092104, der WO-A 2014/151829, der WO-A 2016/058745, der WO-A 2017/069749, der WO-A 2017/123214, der WO-A 2017/137347, der WO-A 2017/143579, der WO-A 2018/160382,der WO-A 2018/174841, der WO-A 85/05677, der WO-A 88/02853, der WO-A 88/03642, der WO-A 89/00679, der WO-A 94/21999, der WO-A 95/03528, der WO-A 95/16897, der WO-A 95/29385, der WO-A 95/29386, der WO-A 98/02725, der WO-A 99/40 394, WO-A 2018/028932, der WO-A 2018/007176, der WO-A 2018/007185 oder der WO-A 2019/068553 beschrieben.

Der Meßaufnehmer eines jeden der darin gezeigten Meßsysteme umfaßt wenigstens ein Vibrationselement, das typischerweise als ein zumindest abschnittsweise gerades und/oder zumindest abschnittsweise gekrümmtes, z.B. U-, V-, S-, Z- oder Ω-artig geformtes, Meßrohr mit einem von einer Rohrwand umgebenen Lumen zum Führen des Meßstoffs ausgebildet ist, oder das - wie u.a. auch in der WO-A 2018/160382, der US-A 2016/0187176 oder der WO-A 2019/068553 gezeigt - beispielsweise auch als ein innerhalb eines Lumens eines vom Meßstoff durchströmten Rohrs plaziertes Verdrängerelement ausgebildet sein kann. Das wenigstens eine Vibrationselement ist dafür eingerichtet, vom Meßstoff kontaktiert, beispielsweise nämlich vom Meßstoff durchströmt und/oder umströmt, und währenddessen vibrieren gelassen zu werden, insb. derart, daß es Nutzschwingungen, nämlich mechanische Schwingungen um eine Ruhelage mit einer auch von der Dichte des Mediums mitbestimmten, mithin als Maß für die Dichte verwendbaren Nutzfrequenz ausführt. Bei herkömmlichen, nicht zuletzt Coriolis-Massedurchfluß-Meßgeräten mit als Meßrohr ausgebildetem Vibrationselement, dienen typischerweise Biegeschwingungen auf einer natürlichen Resonanzfrequenz als Nutzschwingungen, beispielsweise solche Biegeschwingungen, die einem dem Meßaufnehmer immanenten natürlichen Biegeschwingungsgrundmode entsprechen, in dem die Schwingungen des Vibrationselements solche Resonanzschwingungen sind, die genau einen Schwingungsbauch aufweisen. Die Nutzschwingungen sind bei einem zumindest abschnittsweise gekrümmtem Meßrohr als Vibrationselement zudem typischerweise so ausgebildet, daß das nämliches Meßrohr um eine ein einlaßseitiges und ein außlaßseitiges Ende des Meßrohrs imaginär verbindenden gedachte Schwingungsachse nach Art eines an einem Ende eingespannten Auslegers pendelt, während hingegen bei Meßaufnehmern mit einem geraden Meßrohr als Vibrationselement die Nutzschwingungen zumeist Biegeschwingungen in einer einzigen gedachten Schwingungsebene sind.

Es ist zudem bekannt, das wenigstens eine Vibrationselement, beispielsweise zwecks Durchführung wiederkehrender Überprüfungen des Meßaufnehmers während des Betriebs des Meßgeräts, gelegentlich auch zu zeitlich andauernden erzwungenen Schwingungen außer Resonanz anzuregen oder gelegentlich auch freie gedämpfte Schwingungen des wenigstens einen Vibrationselements zu ermöglichen sowie nämliche Schwingungen jeweils auszuwerten, etwa um, wie u.a. auch in der vorgenannten EP-A 816 807, US-A 2011/0178738 oder US-A 2012/0123705 beschrieben, allfällige Beschädigungen des wenigstens einen Vibrationselements möglichst frühzeitig zu detektieren, die eine unerwünschte Verringerung der Meßgenauigkeit und/oder der Betriebssicherheit des jeweiligen Meßgeräts bewirken können.

Bei Meßaufnehmern mit zwei jeweils als Meßrohr ausgebildeten Vibrationselementen sind diese zumeist über ein sich zwischen den Meßrohren und einem einlaßseitigen Anschlußflansch erstreckenden einlaßseitig Verteilerstück sowie über ein sich zwischen den Meßrohren und einem auslaßseitigen Anschlußflansch erstreckenden auslaßseitig Verteilerstück in die jeweilige Prozeßleitung eingebunden. Bei Meßaufnehmern mit einem einzigen Meßrohr als Vibrationselement kommuniziert letzteres zumeist über ein einlaßseitig einmündendes Verbindungsrohr sowie über ein auslaßseitig einmündendes Verbindungsrohr mit der Prozeßleitung. Ferner umfassen Meßaufnehmer mit einem einzigen Meßrohr als Vibrationselement jeweils wenigstens ein weiteres, nämlich als ein, beispielsweise rohr-, kasten- oder plattenförmigen, Gegenschwinger ausgebildetes, gleichwohl nicht vom Meßstoff kontaktiertes Vibrationselement, das unter Bildung einer ersten Kopplungszone einlaßseitig an das Meßrohr gekoppelt ist und der unter Bildung einer zweiten Kopplungszone auslaßseitig an das Meßrohr gekoppelt ist, und das im Betrieb im wesentlichen ruht oder entgegengesetzt zum Meßrohr oszilliert. Das dabei mittels Meßrohr und Gegenschwinger gebildete Innenteil des Meßaufnehmers ist zumeist allein mittels der zwei Verbindungsrohre, über die das Meßrohr im Betrieb mit der Prozeßleitung kommuniziert, in einem schutzgebenden Aufnehmer-Gehäuse gehaltert, insb. in einer Schwingungen des Innenteils relativ zum Aufnehmer-Gehäuse ermöglichenden Weise. Bei den beispielsweise in der US-A 52 91 792, der US-A 57 96 010, der US-A 59 45 609, der US-B 70 77 014, der US-A 2007/0119264, der WO-A 01/02 816 oder auch der WO-A 99/40 394 gezeigten Meßaufnehmern mit einem einzigen, im wesentlichen geraden Meßrohr sind letzteres und der Gegenschwinger, wie bei herkömmlichen Meßaufnehmern durchaus üblich, zueinander im wesentlichen koaxial ausgerichtet, indem der Gegenschwinger als im wesentlichen gerader Hohlzylinder ausgebildet und im Meßaufnehmer so angeordnet ist, daß das Meßrohr zumindest teilweise vom Gegenschwinger ummantelt ist. Als Materialien für solche Gegenschwinger kommen, insb. auch bei Verwendung von Titan, Tantal oder Zirkonium für das Meßrohr, zumeist vergleichsweise kostengünstige Stahlsorten, wie etwa Baustahl oder Automatenstahl, zum Einsatz.

Zum aktiven Anregen bzw. Aufrechterhalten von Schwingungen des wenigstens einen Vibrationselements, nicht zuletzt auch den vorbezeichneten Nutzschwingungen, weisen Meßaufnehmer vom Vibrationstyp des weiteren wenigstens einen im Betrieb auf das wenigstens eine Vibrationselement einwirkenden elektromechanischen, typischerweise ebenfalls elektrodynamischen Schwingungserreger auf. Der mittels eines Paars elektrischer Anschlußleitungen, beispielsweise in Form von Anschlußdrähten und/oder inform von Leiterbahnen einer flexiblen Leiterplatte, mit der vorbezeichneten Meßsystem-Elektronik elektrisch verbundene Schwingungserreger dient im besonderen dazu, angesteuert von einem in der Meßsystem-Elektronik vorgesehenen Antriebselektronik generierten und entsprechend konditionierten, nämlich zumindest an sich verändernde Schwingungseigenschaften des wenigstens einen Vibrationselements angepaßten elektrischen Treibersignal eine mittels nämlichen Treibersignals eingespeiste elektrische Erregerleistung in eine an einem vom Schwingungserreger gebildeten Angriffspunkt auf das wenigstens eine Vibrationselement wirkende Antriebskraft zu wandeln. Die Antriebselektronik ist im besonderen auch dafür eingerichtet, das Treibersignal mittels interner Regelung so einzustellen, daß es eine der anzuregenden, gelegentlich auch zeitlich ändernden Nutzfrequenz entsprechende Signalfrequenz aufweist, ggf. als bei einer durch einen Erregerstrom, nämlich einen elektrischen Strom des Treibersignals vorgegebenen Schwingungsamplitude. Das Treibersignal kann beispielsweise im Betrieb des Meßgeräts gelegentlich auch abgeschaltet werden, beispielsweise zwecks Ermöglichen der vorbezeichneten freien gedämpften Schwingungen des wenigstens einen Vibrationselements oder beispielsweise, wie in der eingangs erwähnten WO-A 2017143579 vorgeschlagen, um die Antriebselektronik vor einer Überlastung zu schützen.

Schwingungserreger marktgängiger Meßaufnehmer vom Vibrationstyp sind typischerweise nach Art einer nach dem elektrodynamischen Prinzip arbeitenden Schwingspule, nämlich einer Luftspule-Magnet-Anordnung aufgebaut, die mittels einer - bei Meßaufnehmern mit einem Meßrohr und einem daran gekoppelten Gegenschwinger gebildeten Vibrationselementen zumeist an letzterem fixierten - Luftspule, nämlich einer keinen magnetischen Kern, sondern vielmehr Luft einschließenden Spule sowie einen mit der wenigstens einen Luftspule wechselwirkenden als Anker dienenden - beispielsweise entsprechend an vorbezeichnetem Meßrohr fixierten - Permanentmagneten gebildet ist und bei der die jeweilige Luftspule zumindest teilweise in einem einen Magnetischer Fluß führenden Luftspalt des Permanentmagneten positioniert ist. Permanentmagneten und Luftspule sind dabei üblicherweise so ausgerichtet, daß sie zueinander im wesentlichen koaxial verlaufen, und zudem dafür eingerichtet, relativ zueinander bzw. gegengleich bewegt zu werden, derart, daß bei durch die Luftspule fließendem Erregerstrom der Permanentmagnet und die in dessen Luftspalt befindliche Luftspule im wesentlichen translatorisch hin- und her bewegt werden. Zudem ist bei herkömmlichen Meßaufnehmern der Schwingungserreger zumeist so ausgebildet und plaziert, daß er im wesentlichen mittig an das wenigstens eine Meßrohr angreift. Alternativ zu einem eher zentral und direkt auf das wenigstens eine Vibrationselement wirkenden Schwingungserreger können, wie u.a. in der eingangs erwähnten US-A 60 92 429, beispielsweise auch mittels zweier nicht im Zentrum des wenigstens einen Vibrationselement, sondern eher ein- bzw. auslaßseitig an diesem fixierten Schwingungserreger zum aktiven Anregung mechanischer Schwingungen des wenigstens einen Vibrationselements verwendet werden oder, wie u.a. in der US-B 62 23 605 oder der US-A 55 31 126 vorgeschlagen, beispielsweise auch mittels eines zwischen dem wenigstens einen Vibrationselement und dem Aufnehmer-Gehäuse wirkender Schwingungserreger verwendet werden.

Aufgrund der Nutzschwingungen des wenigstens einen Vibrationselements, werden - nicht zuletzt auch für den Fall, daß die Nutzschwingungen des wenigstens einen Vibrationselements quer zur Strömungsrichtung auf den strömenden Meßstoff wirkende Biegeschwingungen sind - im Meßstoff bekanntlich auch vom momentanen Massestrom abhängige Corioliskräfte induziert. Diese wiederum können vom Massestrom abhängige, sich den Nutzschwingungen überlagernde Coriolisschwingungen des Vibrationselements, ebenfalls mit Nutzfrequenz, bewirken, derart, daß zwischen einlaßseitigen und auslaßseitigen Schwingungsbewegungen des die Nutzschwingungen ausführenden und zugleich vom Medium durchströmten wenigstens einen Meßrohrs eine auch vom Massestrom abhängige, mithin auch als Maß für die Massestrommessung nutzbare Laufzeit- bzw. Phasendifferenz detektiert werden kann. Bei einem zumindest abschnittsweise gekrümmtem Meßrohr als Vibrationselement, bei dem für die Nutzschwingungen eine Schwingungsform, in der nämliches Meßrohr nach Art eines an einem Ende eingespannten Auslegers pendeln gelassen wird, gewählt ist, entsprechen die resultierenden Coriolisschwingungen beispielsweise jenem - gelegentlich auch als Twist-Mode bezeichneten - Biegeschwingungsmode, in dem das Meßrohr Drehschwingungen um eine senkrecht zur erwähnten gedachten Schwingungsachse ausgerichtete gedachte Drehschwingungsachse ausführt, wohingegen bei einem geraden Meßrohr als Vibrationselement, dessen Nutzschwingungen als Biegeschwingungen in einer einzigen gedachten Schwingungsebene ausgebildet sind, die Coriolisschwingungen beispielsweise als zu den Nutzschwingungen im wesentlichen koplanare Biegeschwingungen sind.

Zum Erfassen sowohl einlaßseitiger als auch auslaßseitiger Schwingungsbewegungen des wenigstens einen Vibrationselements, nicht zuletzt auch den den Nutzschwingungen entsprechenden, und zum Erzeugen wenigstens zweier von der zu messenden Massestrom beeinflußten elektrischen Schwingungsmeßsignalen weisen Meßaufnehmer der in Rede stehenden Art desweiteren zwei oder mehr entlang des wenigstens einen Vibrationselements voneinander beabstandete, beispielsweise jeweils mittels eines eigenen Paars elektrischer Anschlußleitungen mit eine in der vorbezeichneten Meßsystem-Elektronik elektrisch verbundenen, Schwingungssensoren auf. Jeder der Schwingungssensoren ist eingerichtet, die vorbezeichneten Schwingungsbewegungen an einem jeweiligen Meßpunkt zu erfassen und jeweils in ein nämliche Schwingungsbewegungen repräsentierendes elektrisches Schwingungsmeßsignal zu wandeln, das eine Nutzkomponente, nämlich eine (spektrale) Signal- bzw. nämlich eine Wechselspannungskomponente mit einer der Nutzfrequenz entsprechenden (Signal-)Frequenz und einer von der Nutzfrequenz und einem im jeweiligen Schwingungssensor etablierten magnetischer Fluß abhängigen (Signal-)Amplitude enthält, und nämliches Schwingungsmeßsignal jeweils der Meßsystem-Elektronik, beispielsweise nämlich einer mittels wenigstens eines Mikroprozessors gebildeten Meß- und Steuer-Elektronik der Meßsystem-Elektronik, zur weiteren, ggf. auch digitalen Verarbeitung zur Verfügung zu stellen. Zudem sind die wenigstens zwei Schwingungssensoren so ausgestaltet und angeordnet, daß die vorbezeichnete Nutzkomponente der damit generierten Schwingungsmeßsignale zudem jeweils einen vom Massestrom abhängigen Phasenwinkel aufweisen, derart zwischen den Nutzkomponenten beider Schwingungsmeßsignale eine vom Massestrom abhängige Laufzeit- bzw. Phasendifferenz meßbar ist. Basierend auf nämlicher Phasendifferenz ermittelt die Meßsystem-Elektronik wiederkehrend den Massestrom repräsentierende Massedurchfluß-Meßwerte. In Ergänzung zur Messung des Massestroms kann - etwa basierend auf der Nutzfrequenz und/oder auf einer für die Anregung bzw. Aufrechterhaltung der Nutzschwingungen erforderlichen elektrischen Erregerleistung bzw. einer anhand dessen ermittelten Dämpfung der Nutzschwingungen - zusätzlich auch die Dichte und/oder die Viskosität des Mediums gemessen und von der Meßsystem-Elektronik zusammen mit dem gemessenen Massestrom in Form qualifizierter Meßwerte ausgegeben werden. Typischerweise sind die beiden Schwingungssensoren als elektrodynamische Schwingungssensoren ausgebildet, insb. nämlich gleichermaßen wie der wenigstens eine Schwingungserreger jeweils mittels einer - hier als Tauchspule dienlichen - Luftspule-Magnet-Anordnung gebildet, bei der ebenfalls jeweils eine Luftspule zumindest teilweise in einem einen magnetischer Fluß führenden Luftspalt eines zugehörigen Permanentmagneten positioniert ("eingetaucht") ist und bei der zudem Luftspule und Permanentmagnet eingerichtet sind, zwecks Generierens einer Induktionsspannung relativ zueinander bewegt zu werden, derart, daß die Luftspule im Luftspalt im wesentlichen translatorisch hin- und her bewegt wird. Der Permanentmagnet und die Luftspule sind dabei üblicherweise so ausgerichtet, daß sie zueinander im wesentlichen koaxial verlaufen.

Es ist bekannt, daß bei Verwendung von elektrodynamischen Schwingungssensoren die vorbezeichneten Phasenwinkel der Nutzkomponenten jedes der Schwingungsmeßsignale trotz gleichbleibendem Massestroms zeitlich ändern können bzw. daß die zwischen den Nutzkomponenten etablierte Phasendifferenz gelegentlich eine nicht vom Massestrom abhängige Störkomponente aufweisen kann, derart, ein signifikanter Phasenfehler, nämlich eine nicht mehr vernachlässigbare zusätzliche Änderung der Phasendifferenz zu beobachten ist. Weiterführende Untersuchungen an konventionellen vibronischen Meßsystemen, insb. nämlich konventionellen Coriolis-Massedurchfluß-Meßgeräten, haben gezeigt, daß solche Phasenfehler im besonderen für auch den Fall auftreten können, daß das jeweilige Meßsystem, insb. dessen jeweiliger Meßaufnehmer, in der Nähe eines oder mehreren Elektromotoren, Transformatoren, (Elektro-)Magneten, Wechselrichtern oder anderweitigen hohe elektrische Ströme, insb. auch Gleichströme, führenden Anlagenteilen stationiert, mithin einem gelegentlich auch sehr starken externen, nämlich von außerhalb des Meßsystems verursachten, gleichwohl sich auch innerhalb von dessen Meßaufnehmer ausbreitendes zusätzlichen Magnetfeld ausgesetzt ist.

Wie u.a. auch in der eingangs erwähnten WO-A 01/02812 oder US-B 76 65 369 erörtert, besteht eine Möglichkeit zur Reduzierung des vorbezeichneten, auf externe Magnetfelder zurückzuführenden Phasenfehlers beispielsweise darin, das Aufnehmer-Gehäuse durch die Verwendung von Materialien mit einer vergleichsweise hohen relativen magnetischen Leitfähigkeit, beispielsweise Automatenstahl oder Baustahl, so auszubilden, daß dessen effektiver magnetischer Widerstand signifikant verringert wird. Eine weitere Möglichkeit zur Vermeidung von durch externe Magnetfelder bedingten Meßfehlern bestünde, wie in der US-B 76 65 369 ebenfalls vorgeschlagen, auch darin, in den jeweiligen Magnetbechern der Schwingungssensoren die durch externe Magnetfelder hervorgerufenen Wirbelströme unterdrückende Schlitze vorzusehen. Untersuchungen haben allerdings gezeigt, daß die vorbezeichneten Maßnahmen zwar durchaus die in das Aufnehmer-Gehäuse eindringenden Magnetfelder schwächen und dadurch auch eine Beitrag zur Reduzierungen der vorbezeichneten Störkomponente leisten können, daß aber selbst durch eine Vereinigung beider Maßnahmen der Phasenfehler mit vertretbarem technischen Aufwand nicht immer unterhalb eines noch tolerierbaren Ausmaßes verringert werden kann. Im Ergebnis kann bei einem herkömmlichen Coriolis-Massedurchfluß-Meßgerät dementsprechend nicht ohne weiteres ausgeschlossen werden, daß der Massestrom aufgrund eines unbekannten externen, ggf. auch lediglich vorübergehend etablierten und/oder schwankenden, Magnetfeldes unerkannt mit deutlich erhöhten Meßfehlern gemessen wird bzw. entsprechende Massedurchfluß-Meßwerte mit signifikant verringerter Meßgenauigkeit ausgegeben werden.

Ausgehend vom vorbezeichneten Stand der Technik besteht eine Aufgabe der Erfindung darin, vibronische Meßsystem, nicht zuletzt auch Coriolis-Massedurchfluß-Meßgeräte, dahingehend zu verbessern, daß damit auch die Anwesenheit eines exteren Magnetfelds bzw. dessen Einfluß auf die Meßgenauigkeit zumindest detektiert, beispielsweise auch zeitnah entsprechend vermeldet werden kann.

Zur Lösung der Aufgabe besteht die Erfindung in einem vibronischem Meßsystem, beispielsweise Coriolis-Massedurchfluß-Meßgerät oder Coriolis-Massedurchfluß-/Dichte-Meßgerät, zum Messen eines Massestroms eines fluiden Meßstoffs - beispielsweise eines Gases, einer Flüssigkeit oder einer Dispersion -, welches Meßsystem umfaßt:

- einen Meßaufnehmer, der wenigstens ein, beispielsweise rohrförmiges, Vibrationselement, zum Anregen und Aufrechterhalten von mechanischen Schwingungen des wenigstens einen Vibrationselements wenigstens einen Schwingungserreger sowie zum Erfassen mechanischer Schwingungen des wenigstens einen Vibrationselements, beispielsweise dessen Nutzschwingungen, einen elektrodynamischen ersten Schwingungssensor und wenigstens einen, beispielsweise zum ersten Schwingungssensor baugleichen, elektrodynamischen zweiten Schwingungssensor aufweist und der eingerichtet ist, den Meßstoff zu führen, nämlich zumindest zeitweise vom Meßstoff durchströmt zu werden;

- ein Aufnehmer-Gehäuse für den Meßaufnehmer, beispielsweise mit einer Wandung aus einem Metall;

- zum Erfassen eines innerhalb des Meßsystems etablierten, beispielsweise nämlich durch ein außerhalb des Aufnehmer-Gehäuses erzeugtes elektrisches Feld und/oder einen außerhalb des Aufnehmer-Gehäuses positionierten Magneten verursachten und/oder zeitliches konstanten, Magnetfeldes wenigstens einen, beispielsweise mittels eines Hall-Sensors und/oder eines Reedschalters gebildeten, ersten Magnetfelddetektor;

- sowie eine sowohl mit dem Meßaufnehmer, nämlich mit dessen wenigstens einem Schwingungserreger und mit dessen ersten und zweiten Schwingungssensoren, als auch mit dem ersten Magnetfelddetektor elektrisch gekoppelte, beispielsweise mittels wenigstens eines Mikroprozessors gebildete und/oder modular aufgebaute, Meßsystem-Elektronik;

- wobei der Meßaufnehmer innerhalb des Aufnehmer-Gehäuses und der erste Magnetfelddetektor außerhalb des Aufnehmer-Gehäuses positioniert ist, beispielsweise derart, daß das wenigstens eine Vibrationselement am Aufnehmer-Gehäuse gehalten ist und/oder daß der erste Magnetfelddetektor außen am Aufnehmer-Gehäuse angebracht ist;

- wobei das wenigstens eine Vibrationselement eingerichtet ist, vom strömenden Meßstoff kontaktiert und währenddessen vibrieren gelassen zu werden;

- wobei der wenigstens eine Schwingungserreger eingerichtet ist, dorthin eingespeiste elektrische Leistung in erzwungene mechanische Schwingungen des Vibrationselements bewirkende mechanische Leistung zu wandeln;

- wobei die Meßsystem-Elektronik eingerichtet ist, ein elektrisches Treibersignal zu generieren und damit elektrische Leistung in den wenigstens einen Schwingungserreger einzuspeisen, derart, daß das Vibrationselement zumindest anteilig Nutzschwingungen, nämlich erzwungene mechanische Schwingungen mit wenigstens einer Nutzfrequenz, nämlich einer durch das elektrische Treibersignal vorgegebenen, beispielsweise einer Resonanzfrequenz des Meßaufnehmers entsprechenden, Schwingungsfrequenz ausführt, die geeignet sind, im strömendem Meßstoff vom Massestrom abhängige Corioliskräfte zu bewirken;

- wobei der erste Schwingungssensor eingerichtet ist, Schwingungsbewegungen des wenigstens einen Vibrationselements an einem ersten Meßpunkt in ein elektrisches erstes Schwingungsmeßsignal des Meßaufnehmers zu wandeln, derart, daß nämliches erstes Schwingungsmeßsignal wenigstens eine erste Nutzkomponente, nämlich eine Wechselspannungskomponente mit einer der Nutzfrequenz entsprechenden Frequenz, und mit einer von der Nutzfrequenz und einem ersten magnetischen Fluß, nämlich einem magnetischen Fluß durch den ersten Schwingungssensor abhängigen Amplitude aufweist;

- wobei der zweite Schwingungssensor eingerichtet ist, Schwingungsbewegungen des wenigstens einen Vibrationselements an einem vom ersten Meßpunkt entfernten zweiten Meßpunkt in ein elektrisches zweites Schwingungsmeßsignal des Meßaufnehmers zu wandeln, derart, daß nämliches zweites Schwingungsmeßsignal wenigstens eine zweite Nutzkomponente, nämlich eine Wechselspannungskomponente mit einer der Nutzfrequenz entsprechenden Frequenz,und mit einer von der Nutzfrequenz und einem zweiten magnetischen Fluß, nämlich einem magnetischen Fluß durch den zweiten Schwingungssensor abhängigen Amplitude aufweist;

- wobei der erste Magnetfelddetektor eingerichtet ist, das Magnetfeld an einem außerhalb des Aufnehmer-Gehäuses verorteten dritten Meßpunkt zu erfassen und in ein, beispielsweise nämliches Magnetfeld bewertendes und/oder quantifizierendendes und/oder elektrisches, erstes Magnetfeldsignal zu wandeln, das eine von einem dritten magnetischen Fluß, nämlich einem magnetischen Fluß durch den ersten Magnetfelddetektor und/oder von einer Flächendichte nämlichen magnetischen Flusses abhängige Amplitude aufweist, beispielsweise derart, daß das erste Magnetfeldsignal zumindest einer Änderung des dritten magnetischen Flusses und/oder dessen Flächendichte mit einer Änderung der Amplitude folgt;

- und wobei die Meßsystem-Elektronik eingerichtet ist, sowohl die ersten und zweiten Schwingungsmeßsignale als auch zumindest das erste Magnetfeldsignal zu empfangen und auszuwerten, nämlich anhand der ersten und zweiten Schwingungsmeßsignale den Massestrom repräsentierende, beispielsweise digitale, Massestrom-Meßwerte zu ermitteln, beispielsweise nämlich an einem Signalausgang auszugeben, sowie anhand des ersten Magnetfeldsignals zumindest qualitativ zu ermitteln, ob und/oder inwieweit das Magnetfeld an den ersten und/oder zweiten Meßpunkten etabliert ist bzw. einen Beitrag zu den ersten und/oder zweiten magnetischen Flüssen leistet, und/oder zu ermitteln, ob eine, beispielsweise eine Funktionstüchtigkeit des Meßsystems vermindernde und/oder eine Fehlfunktion des Meßsystems bewirkende und/oder eine Integrität zumindest eines der ersten und zweiten Schwingungsmeßsignale bzw. der daraus gewonnenen Massestrom-Meßwerte herabsetzende, Störung des Meßsystems durch nämliches Magnetfeld vorliegt.

Nach einer ersten Ausgestaltung der Erfindung ist ferner vorgesehen, daß das erste Magnetfeldsignal ein, beispielsweise werte- und zeitkontinuierliches, Analogsignal ist, beispielsweise mit einer vom dritten magnetischen Fluß und/oder von dessen Flächendichte abhängigen Spannung. Diese Ausgestaltung der Erfindung weiterbildend ist die Meßsystem-Elektronik ferner eingerichtet, anhand des ersten Magnetfeldsignals Kennzahlenwerte für wenigstens eine, beispielsweise eine Beeinflussung des Meßaufnehmers durch das externe Magnetfeld und/oder eine Beeinflussung zumindest eines der ersten und zweiten magnetischen Flüsse charakterisierende, Magnetfeld-Kennzahl zu berechnen, beispielsweise derart, daß nämliche Magnetfeld-Kennzahl von einer Abweichung des ersten magnetischen Flusses vom zweiten magnetischen Fluß abhängig ist und/oder nämliche Abweichung bewertet und/oder quantifiziert oder daß nämliche Magnetfeld-Kennzahl von einer Abweichung des ersten magnetischen Flusses von einem vorab ermittelten Bezugswert abhängig ist und/oder nämliche Abweichung bewertet und/oder quantifiziert.

Nach einer zweiten Ausgestaltung der Erfindung ist ferner vorgesehen, daß das erste Magnetfeldsignal ein, beispielsweise werte- und zeitkontinuierliches, Analogsignal ist, beispielsweise mit einer vom dritten magnetischen Fluß und/oder von dessen Flächendichte abhängigen Spannung und daß die Meßsystem-Elektronik zudem eingerichtet ist, einen oder mehrere Kennzahlenwerte für die Magnetfeld-Kennzahl jeweils mit einem oder mehreren für die Magnetfeld-Kennzahl, beispielsweise vom Hersteller des Coriolis-Massedurchfluß-Meßgeräts und/oder bei der Herstellung des Coriolis-Massedurchfluß-Meßgerät, ermittelten Bezugswerten, beispielsweise einem oder mehreren eine verminderte Funktionstüchtigkeit des Meßaufnehmers repräsentierenden Bezugswerten und/oder einem oder mehreren eine Fehlfunktion des Meßaufnehmers repräsentierenden Bezugswerten und/oder einem oder mehreren ein nicht mehr intaktes Coriolis-Massedurchfluß-Meßgerät repräsentierenden Bezugswerten, zu vergleichen. Diese Ausgestaltung der Erfindung weiterbildend ist die Meßsystem-Elektronik zudem eingerichtet, zu ermitteln, ob eine oder mehrere Kennzahlenwerte für die Magnetfeld-Kennzahl größer als der wenigstens eine Bezugswert für die Magnetfeld-Kennzahl ist, beispielsweise nämlich falls ein oder mehrere Kennzahlenwerte für die Magnetfeld-Kennzahl größer als ein oder mehrere eine verminderte Funktionstüchtigkeit des Meßaufnehmers repräsentierende Bezugswerte und/oder größer als ein oder mehrere eine Fehlfunktion des Meßaufnehmers repräsentierende Bezugswerte ist und/oder größer als ein oder mehrere ein nicht mehr intaktes Coriolis-Massedurchfluß-Meßgerät repräsentierenden Bezugswerten ist, eine dies signalisierende Meldung auszugeben.

Nach einer dritten Ausgestaltung der Erfindung ist ferner vorgesehen, daß die Meßsystem-Elektronik einen nicht-flüchtigen elektronischen Datenspeicher aufweist, der dafür eingerichtet ist, digitale Daten, insb. auch ohne eine angelegte Betriebsspannung, vorzuhalten, insb. nämlich einen oder mehrere vorab ermittelte Bezugswerte für die Magnetfeld-Kennzahl zu speichern. Diese Ausgestaltung der Erfindung weiterbildend sind im elektronischen Datenspeicher ein oder mehrere, beispielsweise vom Hersteller des Meßsystem und/oder bei der Herstellung des Meßsystem und/oder im Betrieb des Meßsystem vorab ermittelte, Bezugswerte für die Magnetfeld-Kennzahl, beispielsweise nämlich ein oder mehrere eine verminderte Funktionstüchtigkeit des Meßaufnehmers repräsentierende Bezugswerte und/oder nämlich ein oder mehrere eine Fehlfunktion des Meßaufnehmers repräsentierende Bezugswerte, gespeichert. Zudem kann die Meßsystem-Elektronik ggf. auch eingerichtet sein, einen oder mehrere Kennzahlenwerte für die Magnetfeld-Kennzahl jeweils mit einem oder mehreren im Datenspeicher gespeicherten Bezugswerten für die Magnetfeld-Kennzahl zu vergleichen.

Nach einer vierten Ausgestaltung der Erfindung ist ferner vorgesehen, daß der erste Magnetfelddetektor mittels wenigstens eines Hall-Sensors gebildet ist.

Nach einer fünften Ausgestaltung der Erfindung ist ferner vorgesehen, daß der erste Magnetfelddetektor mittels wenigstens eines Reedschalters gebildet ist.

Nach einer sechsten Ausgestaltung der Erfindung ist ferner vorgesehen, daß der erste Magnetfeldetektor weniger weit entfernt vom ersten Schwingungssensor als vom zweiten Schwingungssensor und/oder weniger als 5 cm vom ersten Schwingungssensor entfernt positioniert ist.

Nach einer siebenten Ausgestaltung der Erfindung ist ferner vorgesehen, daß die Meß- und Steuerelektronik einen ersten Analog-zu-Digital-Wandler für das erste Schwingungsmeßsignal sowie einen zweiten Analog-zu-Digital-Wandler für das zweite Schwingungsmeßsignal aufweist. Diese Ausgestaltung der Erfindung weiterbildend weist die Meßsystem-Elektronik ferner einen dritten Analog-zu-Digital-Wandler für das erste Magnetfeldsignal auf.

Nach einer achten Ausgestaltung der Erfindung ist ferner vorgesehen, daß der erste Schwingungssensor mittels einer ersten Tauchspule und der zweite Schwingungssensor mittels einer zweiten Tauchspule gebildet ist.

Nach einer neunten Ausgestaltung der Erfindung ist ferner vorgesehen, daß der erste Schwingungssensor einen, beispielsweise unter Bildung des ersten Meßpunkts mechanisch mit dem wenigstens einen Vibrationselement verbundenen, ersten Permanentmagneten sowie eine erste Luftspule aufweist, derart, daß der erste Permanentmagnet einen den ersten Magnetischer Fluß führenden ersten Luftspalt bildet und die erste Luftspule zumindest teilweise innerhalb nämlichen ersten Luftspalts positioniert ist, und daß der erste Permanentmagnet und die erste Luftspule eingerichtet sind, durch Schwingungsbewegungen des wenigstens einen Vibrationselements relativ zueinander bewegt zu werden und eine als erstes Schwingungsmeßsignal dienliche erste Induktionsspannung zu generieren. Desweiteren ist vorgesehen, daß der zweite Schwingungssensor einen, beispielsweise unter Bildung des zweiten Meßpunkts mechanisch mit dem wenigstens einen Vibrationselement verbundenen, zweiten Permanentmagneten sowie eine zweite Luftspule aufweist, derart, daß der zweite Permanentmagnet einen den zweiten Magnetischer Fluß führenden zweiten Luftspalt bildet und die zweite Luftspule zumindest teilweise innerhalb nämlichen zweiten Luftspalts positioniert ist, und daß der zweite Permanentmagnet und die zweite Luftspule eingerichtet sind, durch Schwingungsbewegungen des wenigstens einen Vibrationselements relativ zueinander bewegt zu werden und eine als zweites Schwingungsmeßsignal dienliche zweite Induktionsspannung zu generieren.

Nach einer zehnten Ausgestaltung der Erfindung ist ferner vorgesehen, daß jede der ersten und zweiten Nutzkomponenten jeweils einen vom Massestrom abhängigen Phasenwinkel aufweist. Diese Ausgestaltung der Erfindung weiterbildend ist die Meßsystem-Elektronik ferner eingerichtet, die Massestrom-Meßwerte anhand einer Phasendifferenz zwischen den ersten und zweiten Nutzkomponenten, nämlich einer Differenz zwischen dem Phasenwinkel der ersten Nutzkomponente und dem Phasenwinkel der zweiten Nutzkomponente zu berechnen.

Nach einer elften Ausgestaltung der Erfindung ist ferner vorgesehen, daß das wenigstens eine Vibrationselement mittels wenigstens eines, z.B. zumindest abschnittsweise geraden und/oder zumindest abschnittsweise kreisbogenförmigen, Rohrs mit einem von einer, beispielsweise metallischen, Rohrwand und einem davon umhüllten Lumen gebildet und dafür eingerichtet ist, von Meßstoff durchströmt und währenddessen vibrieren gelassen zu werden.

Nach einer zwölften Ausgestaltung der Erfindung ist vorgesehen, daß die Meßsystem-Elektronik modular ausgebildet ist, derart daß die Meßsystem-Elektronik ein erstes Elektronik-Modul und ein ein zweites Elektronik-Modul aufweist. Diese Ausgestaltung der Erfindung weiterbildend ist ferner vorgesehen, daß das erste Elektronik-Modul eingerichtet ist, sowohl das Treibersignal zu generieren als auch die ersten und zweiten Schwingungsmeßsignale zu empfangen und auszuwerten und daß das zweite Elektronik-Modul eingerichtet ist das ersten Magnetfeldsignal zu empfangen und auszuwerten. Alternativ oder in Ergänzung können die ersten und zweiten Elektronik-Module der Meßsystem-Elektronik elektrisch miteinander gekoppelt sein, beispielsweise derart, daß das ein Signalausgang des ersten Elektronik-Moduls mit einem Signaleingang des zweiten Elektronik-Moduls elektrisch verbunden ist.

Nach einer ersten Weiterbildung der Erfindung ist vorgesehen, daß das Meßsystem weiters wenigstens ein, beispielsweise modular aufgebautes, Elektronik-Gehäuse umfaßt, wobei die Meßsystem-Elektronik zumindest teilweise, beispielsweise vollständig, innerhalb des Elektronik-Gehäuses untergebracht ist und/oder wobei der erste Magnetfelddetektor außerhalb des Elektronik-Gehäuses positioniert ist. Nach einer Ausgestaltung dieser Weiterbildung ist ferner vorgesehen, daß das Aufnehmer-Gehäuse zudem einen Anschlußstutzen für das Elektronik-Gehäuse aufweist, und daß das Elektronik-Gehäuse mit dem Anschlußstutzen, beispielsweise wiederlösbar, mechanisch verbunden ist.

Nach einer zweiten Weiterbildung der Erfindung ist vorgesehen, daß das Meßsystem weiters wenigstens ein modular aufgebautes Elektronik-Gehäuse, innerhalb dem die Meßsystem-Elektronik zumindest teilweise, beispielsweise vollständig, untergebracht ist, umfaßt, derart, daß das Elektronik-Gehäuse ein erstes Gehäuse-Modul und ein zweites ein erstes Gehäuse-Modul aufweist. Diese Ausgestaltung der Erfindung weiterbildend ist ferner vorgesehen, daß das erste Gehäuse-Modul außen am Aufnehmer-Gehäuse angebracht ist und/oder daß das zweite Gehäuse-Modul außen am ersten Gehäuse-Modul angebracht ist.

Nach einer dritten Weiterbildung der Erfindung ist vorgesehen, daß das Meßsystem weiters wenigstens ein modular aufgebautes Elektronik-Gehäuse, innerhalb dem die Meßsystem-Elektronik zumindest teilweise, beispielsweise vollständig, untergebracht ist, umfaßt, derart, daß das Elektronik-Gehäuse ein erstes Gehäuse-Modul und ein zweites ein erstes Gehäuse-Modul aufweist, und daß die Meßsystem-Elektronik modular ausgebildet ist, derart daß die Meßsystem-Elektronik ein erstes Elektronik-Modul und ein ein zweites Elektronik-Modul aufweist. Nach einer Ausgestaltung dieser Weiterbildung ist ferner vorgesehen, daß das erste Gehäuse-Modul des Elektronik-Gehäuses eingerichtet ist, das erste Elektronik-Modul der Meßsystem-Elektronik aufzunehmen, und daß das zweite Gehäuse-Modul des Elektronik-Gehäuses eingerichtet ist, das zweite Elektronik-Modul der Meßsystem-Elektronik aufzunehmen, und ist zudem vorgesehen, daß das Elektronik-Modul innerhalb des ersten Gehäuse-Moduls und das zweite Elektronik-Modul innerhalb des zweiten Gehäuse-Moduls untergebracht ist. Das erste Elektronik-Modul kann beispielsweise eingerichtet, sowohl das Treibersignal zu generieren als auch die ersten und zweiten Schwingungsmeßsignale zu empfangen und auszuwerten und das zweite Elektronik-Modul kann zudem eingerichtet sein, das ersten Magnetfeldsignal zu empfangen und auszuwerten. Alternativ oder in Ergänzung können die ersten und zweiten Elektronik-Module der Meßsystem-Elektronik elektrisch miteinander gekoppelt sein, beispielsweise derart, daß das ein Signalausgang des ersten Elektronik-Moduls mit einem Signaleingang des zweiten Elektronik-Moduls elektrisch verbunden ist.

Nach einer vierten Weiterbildung der Erfindung ist vorgesehen, daß das Meßsystem weiters einen, beispielsweise metallischen, Schutz-Schild für den wenigstens einen Magnetfelddetektor umfaßt, wobei der Schutz-Schild außerhalb des Aufnehmer-Gehäuses unter Bildung eines zwischen Schutz-Schild und Aufnehmer-Gehäuse verorteten Zwischenraums positioniert, beispielsweise nämlich außen am Aufnehmer-Gehäuse angebracht, ist, und wobei der Magnetfelddetektor innerhalb nämlichen Zwischenraums positioniert ist. Nach einer Ausgestaltung dieser Weiterbildung ist ferner vorgesehen, daß der Schutz-Schild zumindest teilweise aus einem Edelstahl und/oder daß der Schutz-Schild mit dem Aufnehmer-Gehäuse stoffschlüssig verbunden, beispielsweise nämlich damit verschweißt, ist und/oder daß der Schutz-Schild mittels wenigstens einer Plombe am Aufnehmer-Gehäuse gesichert ist.

Nach einer fünften Weiterbildung der Erfindung ist vorgesehen, daß das Meßsystem zum Erfassen des Magnetfeldes wenigstens einen, beispielsweise mittels eines Hall-Sensors und/oder eines Reedschalters gebildeten und/oder zum ersten Magnetfelddetektor baugleichen, zweiten Magnetfelddetektor umfaßt, wobei der zweite Magnetfelddetektor eingerichtet ist, das Magnetfeld an einem vom dritten Meßpunkt entfernten, beispielsweise nämlich auch vom ersten Meßpunkt und/oder vom zweiten Meßpunkten entfernten und/oder außerhalb des Aufnehmer-Gehäuses verorteten, vierten Meßpunkt zu erfassen und in ein, beispielsweise das Magnetfeld bewertendes und/oder quantifizierendendes und/oder elektrisches, zweites Magnetfeldsignal zu wandeln, das eine von einem vierten magnetischen Fluß, nämlich einem magnetischen Fluß durch den zweiten Magnetfelddetektor und/oder von einer Flächendichte nämlichen magnetischen Flusses abhängige Amplitude aufweist; dies beispielsweise derart, daß das zweite Magnetfeldsignal auf zumindest eine Änderung des vierten magnetischen Flusses und/oder dessen Flächendichte mit einer Änderung der Amplitude folgt. Darüberhinaus ist die Meßsystem-Elektronik ferner eingerichtet, auch das zweite Magnetfeldsignal zu empfangen und auszuwerten, nämlich anhand auch des zweiten Magnetfeldsignals zu ermitteln, ob das externe Magnetfeld vorliegt. Nach einer Ausgestaltung dieser Weiterbildung der Erfindung ist ferner vorgesehen, daß der zweite Magnetfeldetektor in der Nähe des zweiten Schwingungssensors, beispielsweise nämlich weniger als 5 cm entfernt, positioniert ist, und/oder daß das zweite Magnetfeldsignal ein Analogsignal ist, beispeilsweise mit einer vom vierten magnetischen Fluß und/oder von dessen Flächendichte abhängigen Spannung, und/oder daß auch der zweite Magnetfelddetektor außerhalb des Aufnehmer-Gehäuses positioniert ist, beispielsweise derart, daß der zweite Magnetfelddetektor außen am Aufnehmer-Gehäuse (100) angebracht ist.

Ein Grundgedanke der Erfindung besteht darin, durch externe Magnetfelder gelegentlich auftretende Beeinflussung der Schwingungssensoren von, insb. als Coriolis-Massedurchfluß-Meßgeräten ausgebildeten, vibronischen Meßsystemen bzw. von deren Schwingungsmeßsignalen mittels wenigstens eines zusätzlichen, gleichwohl außerhalb des jeweiligen Aufnehmer-Gehäuses positionierten Magnetfelddetektors dezidiert zu erfassen und ggf. entsprechend zu vermelden. Ein Vorteil der Erfindung besteht u.a. darin, daß damit auch bestehende, nicht zuletzt auch bereits installierte Meßsysteme ohne weiteres nachgerüstet werden können.

Die Erfindung sowie vorteilhafte Ausgestaltungen davon werden nachfolgend anhand von Ausführungsbeispielen näher erläutert, die in den Figuren der Zeichnung dargestellt sind. Gleiche bzw. gleichwirkende oder gleichartig fungierende Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung und/oder aus den Ansprüchen an sich.

Im einzelnen zeigen:

Fig. 1          ein, hier mittels eines Coriolis-Massedurchfluß-Meßgeräts gebildetes, vibronisches Meßsystem;

Fig. 2          schematisch nach Art eines Blockschaltbildes eine, insb. auch für ein Meßsystem gemäß den Fig. 1 geeignete, Meßsystem-Elektronik mit daran angeschlossenem Meßaufnehmer vom Vibrationtyp bzw. ein Coriolis-Massedurchfluß-Meßgerät gemäß den Fig. 1;

Fig. 3          ein Phasor-Diagramm (Zeigerdiagramm mit ruhenden Zeigern) für Signalkomponenten von mittels eines Coriolis-Massedurchfluß-Meßgeräts gemäß Fig. 1 bzw. mittels einer an einen Meßaufnehmer vom Vibrationstyp angeschlossenen Meßsystem-Elekronik gemäß Fig. 2 generierte Schwingungsmeßsignale;

Fig. 4a, 4b     schematisch jeweils einen Schwingungssensor und einen Magnetfeldsensor eines Meßaufnehmer gemäß Fig. 2 sowie Feldlinien eines den Meßaufnehmer jeweils durchdringenden Magnetfelds;

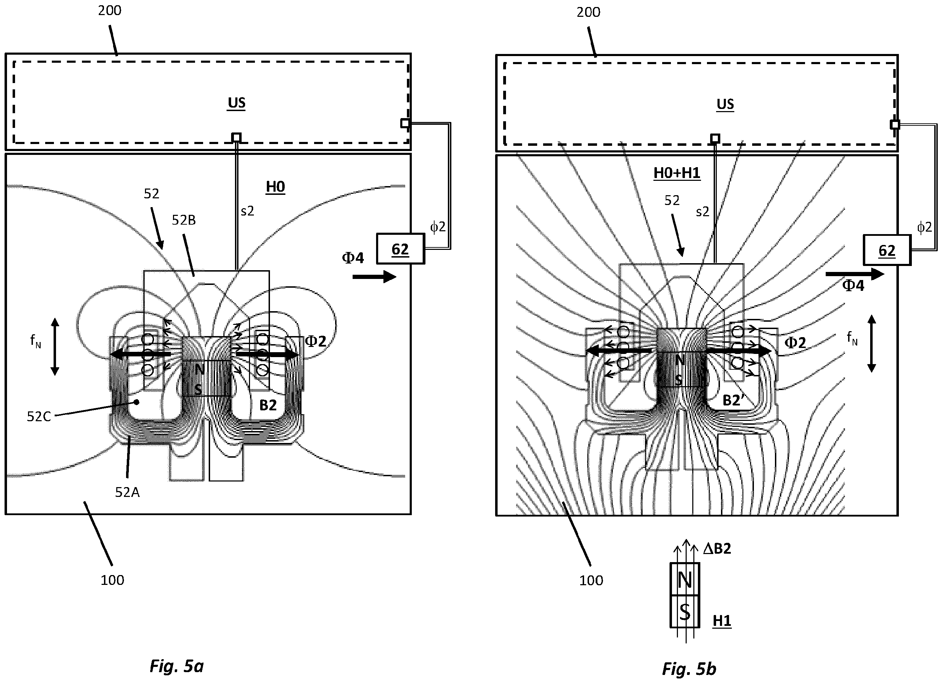

Fig. 5a, 5b     schematisch jeweils einen weiteren Schwingungssensor des Meßaufnehmer gemäß Fig. 4a bzw. 4b sowie Feldlinien des den Meßaufnehmer jeweils durchdringenden Magnetfelds.

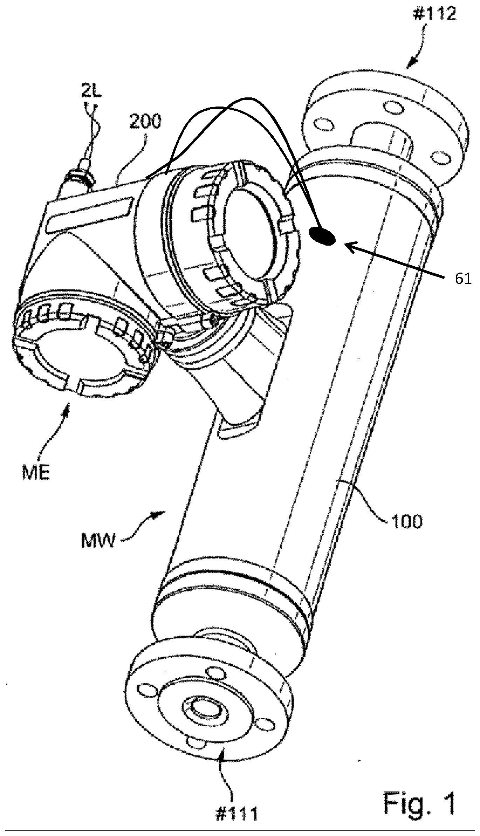

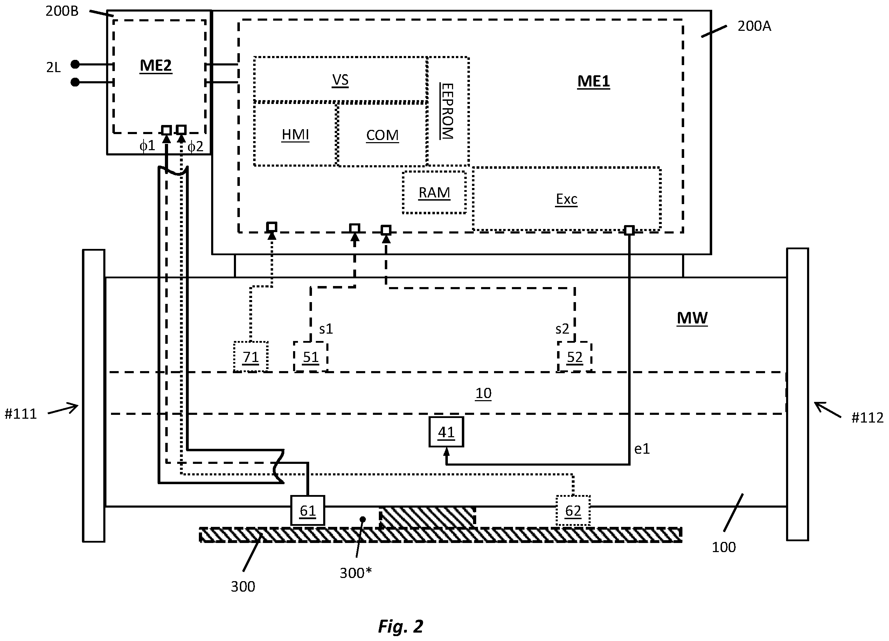

In der Fig. 1 bzw. 2 ist ein in eine (hier nicht dargestellte) Prozeßleitung - wie z.B. eine Rohrleitung einer industriellen Anlage, beispielsweise einer Abfüllanlagen oder einer Betankungsvorrichtung - einfügbares vibronisches Meßsystem für fließfähige, insb. fluide bzw. schüttfähige, Meßstoffe, beispielsweise nämlich auch eines zumindest zeitweise 2- oder mehrphasigen bzw. inhomogenen Fluids, dargestellt. Das Meßsystem dient im besonderen dem Messen und/oder Überwachen einer Massestrom m bzw. dem Ermitteln von die Massestrom repräsentierenden Massestrom-Meßwerten eines in der vorbezeichneten Prozeßleitung geführten bzw. darin zumindest zeitweise strömen gelassenen fluiden Meßstoffs, beispielsweise nämlich eines Gases, einer Flüssigkeit oder einer Dispersion. Ferner kann das Meßsystem dazu dienen, zusätzlich auch eine Dichte ρ und/oder eine Viskosität η, des Meßstoffs zu messen, beispielsweise nämlich die Dichte repräsentierende Dichte-Meßwerte und/oder die Viskosität repräsentierende Viskositäts-Meßwerte zu ermitteln und auszugeben. Nach einer Ausgestaltung der Erfindung ist vorgesehen, das Meßsystem zum Ermitteln von Massestrom-Meßwerten eines zu transferierenden, beispielsweise nämlich mit einer vorgegebenen bzw. vorgebbaren Menge von einem Lieferanten an einen Abnehmer zu übergebenden Meßstoffs zu verwenden, beispielsweise ein verflüssigtes Gas, wie z.B. ein Methan und/oder Ethan und/oder Propan und/oder Buthan enthaltendes Flüssiggas bzw. ein verflüssigtes Erdgas (LNG) oder auch ein mittels flüssiger Kohlenwasserstoffe gebildetes Stoffgemisch, beispielsweise nämlich ein Erdöl oder ein flüssiger Kraftstoff. Das Meßsystem kann dementsprechend beispielsweise auch als Bestandteil einer Übergabestelle für eichpflichtigen Güterverkehr, wie etwa einer Betankungsanlage, und/oder als ein Bestandteil einer Übergabestelle, beispielsweise auch nach Art der in der erwähnten der WO-A 02/060805, der WO-A 2008/013545, der WO-A 2010/099276, der WO-A 2014/151829, der WO-A 2016/058745 gezeigten Übergabestellen, ausgebildet sein.

Das - beispielsweise als Coriolis-Masse-Durchfluß-Meßgerät oder auch als zusätzlich die Dichte messendes Coriolis-Massedurchfluß-/Dichte-Meßgerät und/oder als zusätzlich die Viskosität messendes Coriolis-Massedurchfluß-/Viskosität-Meßgerät realisierte - Meßsystem umfaßt einen über ein Einlaßende #111 sowie ein Auslaßende #112 an die Prozeßleitung angeschlossenen physikalisch-elektrischen Meßaufnehmer MW, der dafür eingerichtet ist, im Betrieb vom Meßstoff durchströmt zu werden, sowie eine damit elektrisch gekoppelte - insb. mittels wenigstens eines Mikroprozessors gebildete und/oder im Betrieb mittels interner Energiespeicher und/oder von extern via Anschlußkabel mit elektrischer Energie versorgte - elektronische Meßsystem-Elektronik ME. Das elektrische Koppeln bzw. Anschließen des Meßaufnehmers MW an die Meßsystem-Elektronik ME kann mittels entsprechender elektrischer Anschlußleitungen und entsprechender Kabeldurchführungen erfolgen. Die Anschlußleitungen können dabei zumindest anteilig als elektrische, zumindest abschnittsweise in von einer elektrischen Isolierung umhüllte Leitungsdrähte ausgebildet sein, z.B. in Form von "Twisted-pair"-Leitungen, Flachbandkabeln und/oder Koaxialkabeln. Alternativ oder in Ergänzung dazu können die Anschlußleitungen zumindest abschnittsweise auch mittels Leiterbahnen einer, insb. flexiblen, gegebenenfalls lackierten Leiterplatte gebildet sein.

In vorteilhafter Weise kann die, beispielsweise auch programmierbare und/oder fernparametrierbare, Meßsystem-Elektronik ME ferner so ausgelegt sein, daß sie im Betrieb des Meßsytems mit einem diesem übergeordneten (hier nicht dargestellten) elektronischen Datenverarbeitungssystem, beispielsweise einer speicherprogrammierbaren Steuerung (SPS), einem Personalcomputer und/oder einer Workstation, via Datenübertragungssystem, beispielsweise einem Feldbussystem und/oder drahtlos per Funk, Meß- und/oder andere Betriebsdaten, beispielsweise auch Statusmeldungen, austauschen kann, wie etwa aktuelle Meßwerte oder der Steuerung des Meßsystems dienende Einstell- und/oder Diagnosewerte. Dementsprechend kann die Meßsystem-Elektronik ME beispielsweise eine solche Sende- und Empfangselektronik COM aufweisen, die im Betrieb von einer im vorbezeichneten Datenverarbeitungssystem vorgesehen, vom Meßsystem entfernten (zentrale) Auswerte- und Versorgungseinheit gespeist wird. Beispielsweise kann die Meßsystem-Elektronik ME (bzw. deren vorbezeichnete Sende- und Empfangselektronik COM) so ausgebildet sein, daß sie über eine, ggf. auch als 4-20 mA-Stromschleife konfigurierte Zweileiter-Verbindung 2L mit dem vorbezeichneten externen elektronischen Datenverarbeitungssystem elektrisch verbindbar ist und darüber sowohl die für den Betrieb des Meßsystems erforderliche elektrische Leistung von der vorbezeichneten Auswerte- und Versorgungseinheit des Datenverarbeitungssystems beziehen als auch Meßwerte zum Datenverarbeitungssystem übermitteln kann, beispielsweise durch (Last-)Modulation eines von der Auswerte- und Versorgungseinheit gespeisten Versorgungsgleichstroms Versorgungsgleichstromes. Zudem kann die Meßsystem-Elektronik ME auch so ausgebildet sein, daß sie nominell mit einer maximalen Leistung von 1 W oder weniger betrieben werden kann und/oder eigensicher ist. Die Meßsystem-Elektronik 20 des erfindungsgemäßen Meßsystems kann zudem beispielsweise auch modular aufgebaut sein, derart, daß diverse Elektronik-Komponenten der Meßsystem-Elektronik ME, wie etwa eine Antriebselektronik Exc zum Ansteuern des Meßaufnehmers, eine Meß- und Steuerelektronik DSV zum Verarbeiten von vom Meßaufnehmer bereitgestellten Meßsignalen und zum Ermitteln von Meßwerten anhand von Meßsignalen des Meßaufnehmers, eine interne Energieversorgungsschaltung VS zum Bereitstellen einer oder mehrerer interner Betriebsspannungen und/oder die vorbezeichnete, der Kommunikation mit einem übergeordneten Meßdatenverarbeitungssystem bzw. einem externen Feldbus dienliche Sende- und Empfangselektronik COM, jeweils auf einer eigenen Leiterplatte angeordnet und/oder jeweils mittels eines eigenen Mikroprozessores gebildet sind. Dementsprechend ist die Meßsystem-Elektronik ME nach einer weiteren Ausgestaltung der Erfindung modular ausgebildet, derart, daß die Meßsystem-Elektronik ME ein erstes Elektronik-Modul ME1 und ein damit elektrisch gekoppeltes, beispielsweise nämlich mittels elektrischen Verbindungsleitungen damit elektrisch verbundenes, zweites Elektronik-Modul ME2 aufweist; dies beispielsweise derart, daß ein Signalausgang des Elektronik-Moduls ME1 mit einem Signaleingang des Elektronik-Moduls ME2 elektrisch verbunden ist. Der vorbezeichnete Signalausgang des Elektronik-Moduls ME1 kann beispielsweise dazu ausgestaltet sein, anhand von Meßsignalen des Meßaufnehmers ermittelte digitale Meßwerte, insb. nämlich die vorbezeichneten Massestrom-, Dichte- bzw. Viskositäts-Meßwerte auszugeben. Zum Visualisieren von Meßsystem intern erzeugten Meßwerten und/oder Meßsystem intern generierten Statusmeldungen, wie etwa eine Fehlermeldung oder einen Alarm, vor Ort kann das Meßsystem desweiteren ein, zumindest zeitweise auch mit der Meßsystem-Elektronik 20, beispielsweise nämlich deren vorbezeichneten Meß- und Steuerelektronik DSV, kommunizierendes Anzeige- und Bedienelement HMI aufweisen, wie etwa ein in vorbezeichnetem Elektronik-Gehäuse 200 hinter einem darin entsprechend vorgesehenen Fenster plaziertes LCD-, OLED- oder TFT-Display sowie eine entsprechende Eingabetastatur und/oder ein Touchscreen.

Zum Schutz der Meßsystem-Elektronik ME weist das Meßsystem gemäß einer weiteren Ausgestaltung der Erfindung ein, beispielsweise auch modular aufgebautes, Elektronik-Gehäuse 200 auf und ist die Meßsystem-Elektronik ME zumindest teilweise, ggf. auch vollständig innerhalb nämlichen Elektronik-Gehäuses 200 untergebracht. Nach einer weiteren Ausgestaltung der Erfindung ist das Elektronik-Gehäuse 200 modular ausgebildet, derart daß das Elektronik-Gehäuse 200 ein erstes Gehäuse-Modul 200A sowie ein, beispielsweise direkt mit nämlichem Gehäuse-Modul 200A mechanisch verbundenes, zweites Gehäuse-Modul 200B aufweist. Für den vorbezeichneten Fall, daß die Meßsystem-Elektronik ME mittels zweier Elektronik-Module ME1, ME2 gebildet ist, kann das Gehäuse-Modul 200A ferner dafür eingerichtet sein, das Elektronik-Modul ME1 aufzunehmen, und kann das Gehäuse-Modul 200B dementsprechend dafür eingerichtet sein, das Elektronik-Modul ME2 aufzunehmen. Das Elektronik-Gehäuse 200 bzw. ein jeweiliges Gehäuse-Modul davon kann beispielsweise aus einem Metall, etwa Edelstahl oder Aluminium, und/oder mittels eines Gießverfahrens, wie z.B. einem Feinguß- oder einem Druckgußverfahren (HPDC), hergestellt sein; es kann aber beispielsweise auch mittels eines in einem Spritzgießverfahren hergestellten Kunststoffformteils gebildet sein. Darüberhinaus kann das Elektronik-Gehäuse 200 bzw. können die vorbezeichneten Gehäuse-Module auch schlag- bzw. druckfest und/oder gegen Eindringen von Staub in schädigenden Mengen und/oder allseitigem Spritzwasser schützend ausgebildete sein, beispielsweise auch derart, daß es den Anforderungen der Schutzart IP 54 gemäß DIN EN 60529 (VDE 0470-1):2014-09 und/oder den Anforderungen der Zündschutzart "Druckfeste Kapslung (Ex-d)" gemäß EN 60079-1:2007 genügt.

Bei dem Meßaufnehmer MW handelt es sich, wie bereits angedeutet, um einen Meßaufnehmer vom Vibrationstyp, nämlich einen Meßaufnehmer mit wenigstens einem Vibrationselement 10, mit wenigstens einem elektromechanischen Schwingungserreger 41 zum Anregen und Aufrechterhalten von mechanischen Schwingungen des wenigstens einen Vibrationselements 10 sowie mit einem einen elektrodynamischen ersten Schwingungssensor 51 und wenigstens einen, beispielsweise zum Schwingungssensor 51 baugleichen, elektrodynamischen zweiten Schwingungssensor 52 zum Erfassen mechanischer Schwingungen des wenigstens einen Vibrationselements 10, wobei sowohl der Schwingungserreger 41 als auch die Schwingungssensoren 51, 52 jeweils mit der Meßsystem-Elektronik 20 elektrisch gekoppelt sind und wobei das wenigstens eine Vibrationselement 10 eingerichtet ist, von strömendem Meßstoff kontaktiert, beispielsweise nämlich von Meßstoff durchströmt und/oder umströmt, zu werden und währenddessen vibrieren gelassen zu werden, beispielsweise nämlich mit wenigstens einer dem Vibrationselement bzw. dem damit gebildeten Meßaufnehmer innewohnenden Resonanzfrequenz. Bei dem Meßaufnehmer kann es sich dementsprechend beispielsweise auch um einen konventionellen - beispielsweise nämlich auch aus den eingangs erwähnten EP-A 816 807, US-A 2002/0033043, US-A 2006/0096390, US-A 2007/0062309, US-A 2007/0119264, US-A 2008/0011101, US-A 2008/0047362, US-A 2008/0190195, US-A 2008/0250871, US-A 2010/0005887, US-A 2010/0011882, US-A 2010/0257943, US-A 2011/0161017, US-A 2011/0178738, US-A 2011/0219872, US-A 2011/0265580, US-A 2011/0271756, US-A 2012/0123705, US-A 2013/0042700, US-A 2016/0313162, US-A 2017/0261474, US-A 44 91 009, US-A 47 56 198, US-A 47 77 833, US-A 48 01 897, US-A 48 76 898, US-A 49 96 871, US-A 5009 109, US-A 52 87 754, US-A 52 91 792, US-A 53 49 872, US-A 57 05 754, US-A 57 96 010, US-A 57 96 011, US-A 58 04 742, US-A 58 31 178, US-A 59 45 609, US-A 59 65 824, US-A 60 06 609, US-A 60 92 429, US-B 62 23 605, US-B 63 11 136, US-B 64 77 901, US-B 65 05 518, US-B 65 13 393, US-B 66 51 513, US-B 66 66 098, US-B 67 11 958, US-B 68 40 109, US-B 69 20 798, US-B 70 17 424, US-B 70 40 181, US-B 70 77 014, US-B 72 00 503, US-B 72 16 549, US-B 72 96 484, US-B 73 25 462, US-B 73 60 451, US-B 77 92 646, US-B 79 54 388, US-B 83 33 120, US-B 86 95 436, WO-A 00/19175, WO-A 00/34748, WO-A 01/02816, WO-A 01/71291, WO-A 02/060805, WO-A 2005/093381, WO-A 2007/043996, WO-A 2008/013545, WO-A 2008/059262, WO-A 2010/099276, WO-A 2013/092104, WO-A 2014/151829, WO-A 2016/058745, WO-A 2017/069749, WO-A 2017/123214, WO-A 2017/143579, WO-A 85/05677, WO-A 88/02853, WO-A 89/00679, WO-A 94/21999, WO-A 95/03528, WO-A 95/16897, WO-A 95/29385, WO-A 98/02725, WO-A 99/40 394 oder PCT/EP2017/067826 bekannten - Meßaufnehmer vom Vibrationstyp handeln.

Das wenigstens eine Vibrationselement 10 ist - wie auch in Fig. 2 angedeutet bzw. aus einer Zusammenschau der Fig. 1 und 2 ohne weiteres ersichtlich - zusammen mit der dem wenigstens einen Schwingungserreger 41 und den wenigstens zwei Schwingungssensoren 51, 52 sowie ggf. weiteren Komponenten des Meßaufnehmers MW innerhalb eines Aufnehmer-Gehäuses 100 des Meßsystems untergebracht; dies insb. derart, daß das wenigstens eine Vibrationselement 10 am Aufnehmer-Gehäuse 100 gehalten ist, beispielsweise nämlich starr mit dem Aufnehmer-Gehäuse 100 verbunden ist. Nach einer weiteren Ausgestaltung der Erfindung weist nämliches Aufnehmer-Gehäuse 100 eine Wandung aus einem Metall, beispielsweise nämlich einem Edelstahl auf. Zudem kann beispielsweise das vorbezeichnete Elektronik-Gehäuse 200 - wie auch in Fig. 1 bzw. 2 dargestellt - unter Bildung eines Durchfluß-Meßgeräts, beispielsweise nämlich eines Coriolis-Massedurchfluß-Meßgeräts, in Kompaktbauweise an nämliches Aufnehmer-Gehäuse 100 montiert sein. Dementsprechend weist das Aufnehmer-Gehäuse 100 nach einer weiteren Ausgestaltung der Erfindung einen Anschlußstutzen für das Elektronik-Gehäuse auf und ist das Elektronik-Gehäuse 200 mit dem Anschlußstutzen, ggf. auch wiederlösbar, mechanisch verbunden. Für den vorbezeichneten Fall, daß das Elektronik-Gehäuse 200 modular ausgebildet ist, kann insbesondere das Gehäuse-Modul 200A außen am Aufnehmer-Gehäuse 100 angebracht sein, beispielsweise derart, daß das Gehäuse-Modul 200A außen am Aufnehmer-Gehäuse 100 und daß das Gehäuse-Modul 200B außen am Gehäuse-Modul 200A angebracht ist.

Das Vibrationselement 10 kann zudem - wie bei Meßaufnehmern der in Rede stehenden Art bzw. damit gebildeten vibronischen Meßsystemen üblich - beispielsweise mittels eines oder mehreren, insb. zumindest abschnittsweise geraden und/oder zumindest abschnittsweise kreisbogenförmigen, Rohren mit einem von einer, insb. metallischen, Rohrwand und einem davon umhüllten Lumen gebildet sein, wobei das Rohr bzw. jedes der Rohre zudem jeweils dafür eingerichtet ist, den zumindest zeitweise strömenden fluiden Meßstoff zu führen (bzw. von nämlichem Meßstoff durchströmt zu werden) und währenddessen entsprechend vibrieren gelassen zu werden. Das Vibrationselement kann beispielsweise aber auch mittels eines oder mehreren innerhalb eines Lumens eines vom Meßstoff durchströmten Rohrs des Meßaufnehmers plazierten Verdrängerelementen gebildet sein, wobei das Verdrängerelement bzw. jedes der Verdrängerelemente jeweils dafür eingerichtet ist, von Meßstoff umströmt und währenddessen entsprechend vibrieren gelassen zu werden.

Der wenigstens eine Schwingungserreger 41 wiederum ist dafür eingerichtet, dorthin eingespeiste elektrische Leistung in erzwungene mechanische Schwingungen des wenigstens einen Vibrationselements 11 bewirkende mechanische Leistung zu wandeln. Nach einer weiteren Ausgestaltung der Erfindung ist der wenigstens eine, beispielsweise als ein elektrodynamischer, elektromagnetischen oder piezoelektrischer ausgebildete, Schwingungserreger 41 - wie auch in Fig. 2 angedeutet und bei Meßaufnehmern vom Vibrationstyp bzw. damit gebildeten vibronischen Meßsystemen durchaus üblich - so positioniert, daß eine damit generierte Kraft in Richtung einer durch einen Massenschwerpunkt des wenigstens einen Vibrationselements verlaufenden gedachten Kraftwirkungslinie auf das Vibrationselement wirkt, und/oder daß der Schwingungserreger 41 - wie auch in Fig. 2 dargestellt - der einzige Schwingungen des Vibrationselements 10 bewirkende Schwingungserreger ist.

Die Meßsystem-Elektronik ME des erfindungsgemäßen Meßsystems ist zudem u.a. dafür vorgesehen und entsprechend eingerichtet, ein - beispielsweise bipolares und/oder zumindest zeitweise periodisches, ggf. auch harmonisches - elektrisches Treibersignal e1 zu generieren und damit elektrische Leistung in den wenigstens eine Schwingungserreger 41 einzuspeisen, derart, daß das wenigstens eine Vibrationselement 10 zumindest anteilig Nutzschwingungen, nämlich erzwungene mechanische Schwingungen mit einer Nutzfrequenz $f_N$ ausführt, die geeignet sind, im strömendem Meßstoff vom Massestrom abhängige, gleichwohl auf das Vibrationselement 10 zurückwirkende Corioliskräfte zu erzeugen, derart, daß den vorbezeichneten Nutzschwingungen Coriolisschwingungen, nämlich durch die Corioliskräfte zusätzlich erzwungene, vom Massestrom m des Meßstoffs abhängige mechanische Schwingungen mit der Nutzfrequenz $f_N$ überlagert sind. Bei der Nutzfrequenz $f_N$ handelt es sich um eine durch das elektrische Treibersignal e1 vorgegebenen, beispielsweise der vorbezeichneten Resonanzfrequenz $f_R$ des Meßaufnehmers entsprechenden, Schwingungsfrequenz der erzwungenen mechanischen Schwingungen des Vibrationselements ($f_N = f_R$). Das Treibersignal e1 kann dementsprechend beispielsweise ein die vorbezeichnete, die Nutzfrequenz $f_N$ bestimmende Signalkomponente e1$_N$ bildendes harmonisches elektrisches Signal oder beispielsweise auch ein sich aus mehreren (spektrale) Signalkomponenten zusammensetzendes, gleichwohl eine die Nutzfrequenz f$_N$ bestimmende spektrale Nutzkomponente e1$_N$ enthaltendes, mehrfrequentes elektrisches Signal sein. Bei den mittels Schwingungserregers 41 und daran angeschlossener Meßsystem-Elektronik ME angeregten Nutzschwingungen kann es ferner beispielsweise um Biegeschwingungen des wenigstens einen Vibrationselements 10 um ein zugehörige Ruhelage handeln, wobei als Nutzfrequenz f$_N$ beispielsweise eine auch von der Dichte und/oder der Viskosität des im Meßaufnehmer geführten bzw. dessen Vibrationselement 10 kontaktierenden Meßstoffs abhängige momentane Resonanzfrequenz eines lediglich einen einzigen Schwingungsbauch aufweisenden Biegeschwingungsgrundmodes des wenigstens einen Vibrationselements 10 und/oder eine niedrigste momentane Resonanzfrequenz des wenigstens einen Vibrationselements 10 ausgewählt, nämlich mittels des Treibersignals e1 eingestellt sein kann. Zum Erzeugen des Treibersignals e1 bzw. zum Einstellen der Nutzfrequenz f$_N$ kann die Meßsystem-Elektronik ME beispielsweise eine entsprechende, insb. mittels einer oder mehreren dem Ermitteln und Einstellen der Nutzfrequenz f$_N$ dienlichen Phasenregelschleifen (PLL - phase locked loop) gebildete, Antriebselektronik Exc aufweisen. Nach einer weiteren Ausgestaltung der Erfindung weist die Antriebselektronik Exc einen digitalen Frequenzausgang auf. Zudem ist die Antriebselektronik Exc ferner auch dafür eingerichtet, an nämlichem Frequenzausgang eine Frequenzfolge, nämlich eine Folge von die für das Treibersignal e1 eingestellte Signalfrequenz, beispielsweise nämlich die momentan eingestellte Nutzfrequenz (bzw. die Signalfrequenz von dessen Signalkomponente eN1), quantifizierenden digitalen Frequenzwerten auszugeben.

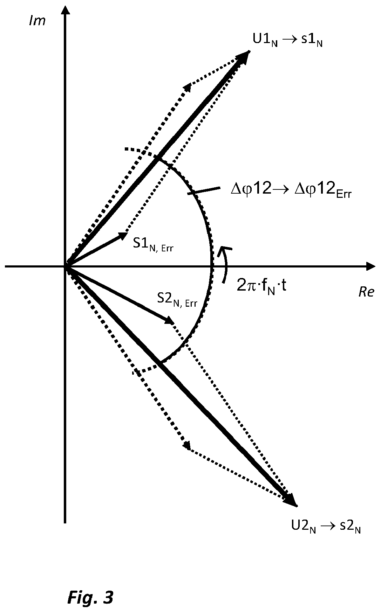

Wie bereits erwähnt, ist der Meßaufnehmer MW ferner auch mit elektrodynamischen Schwingungssensoren 51, 52 ausgestattet, um mechanische Schwingungen des wenigstens einen Vibrationselements 11, nicht zuletzt auch erzwungene mechanische Schwingungen des wenigstens einen Vibrationselements 11, zu erfassen, wobei der Schwingungssensor 51 beispielsweise mittels einer ersten Tauchspule und der Schwingungssensor 52 beispielsweise mittels einer zweiten Tauchspule gebildet sein kann. Im besonderen ist der Schwingungssensor 51 dafür eingerichtet, Schwingungsbewegungen des wenigstens einen Vibrationselements 11 an einem ersten Meßpunkt in ein elektrisches erstes Schwingungsmeßsignal s1 des Meßaufnehmers zu wandeln, derart, daß - wie auch in Fig. 3 angedeutet - nämliches Schwingungsmeßsignal s1 wenigstens eine (von der Zeit t abhängige) erste Nutzkomponente s1$_N$, nämlich eine Wechselspannungskomponente mit einer der Nutzfrequenz f$_N$ entsprechenden Frequenz aufweist, und ist der Schwingungssensor 52 dafür eingerichtet, Schwingungsbewegungen des wenigstens einen Vibrationselements an einem vom ersten Meßpunkt entfernten zweiten Meßpunkt in ein elektrisches zweites Schwingungsmeßsignal s2 des Meßaufnehmers zu wandeln, derart, daß - wie auch in Fig. 3 angedeutet - nämliches Schwingungsmeßsignal s2 wenigstens eine (von der Zeit t abhängige) zweite Nutzkomponente s2$_N$, nämlich eine Wechselspannungskomponente mit einer der Nutzfrequenz f$_N$ entsprechenden Frequenz aufweist. Indem es sich bei jedem der beiden Schwingungssensoren 51, 52 jeweils um einen elektrodynamischen Schwingungssensor handelt, weisen dementsprechend die Nutzkomponente s1$_N$ eine von der Nutzfrequenz f$_N$ sowie von einem ersten magnetischen Fluß Φ1, nämlich einem magnetischen Fluß durch den Schwingungssensor 51 abhängige Amplitude U1$_N$ (bzw. abhhängigen Spannungspegel) und die Nutzkomponente s2$_N$ eine von der Nutzfrequenz f$_N$ sowie von einem zweiten magnetischen Fluß Φ2, nämlich einem magnetischen Fluß durch den Schwingungssensor 52 abhängige Amplitude U2$_N$ (bzw. abhängigen Spannungspegel) auf. Jeder der beiden Schwingungssensoren kann, wie bei Meßaufnehmern der in Rede stehenden Art durchaus üblich, beispielsweise jeweils mittels einer Tauchspule gebildet sein. Dementsprechend ist nach einer weiteren Ausgestaltung der Erfindung vorgesehen, daß der erste Schwingungssensor einen, beispielsweise nämlich unter Bildung des ersten Meßpunkts mechanisch mit dem wenigstens einen Vibrationselement verbundenen, ersten Permanentmagneten sowie eine, beispielsweise mechanisch mit dem wenigstens einen Vibrationselement 11 und/oder mit dem Aufnehmer-Gehäuse 100 verbundene, erste Luftspule aufweist und daß der zweite Schwingungssensor einen, beispielsweise nämlich unter Bildung des zweiten Meßpunkts mechanisch mit dem wenigstens einen Vibrationselement 11 verbundenen, zweiten Permanentmagneten sowie eine, beispielsweise mechanisch mit dem wenigstens einen Vibrationselement und/oder mit dem Aufnehmer-Gehäuse 100 verbundene, zweite Luftspule aufweist. Der erste Permanentmagnet bildet einen den magnetischer Fluß Φ1 führenden ersten Luftspalt innerhalb dem die erste Luftspule zumindest teilweise positioniert ist und der zweite Permanentmagnet bildet einen den magnetischer Fluß Φ2 führenden zweiten Luftspalt innerhalb dem die zweite Luftspule zumindest teilweise positioniert ist. Ferner sind der erste Permanentmagnet und die erste Luftspule eingerichtet, durch Schwingungsbewegungen des wenigstens einen Vibrationselements relativ zueinander bewegt zu werden und eine als Schwingungsmeßsignal s1 dienliche erste Induktionsspannung (u$_{i1}$) zu generieren, und sind der zweite Permanentmagnet und die zweite Luftspule eingerichtet, durch Schwingungsbewegungen des wenigstens einen Vibrationselements 11 relativ zueinander bewegt zu werden und eine als Schwingungsmeßsignal s2 dienliche zweite Induktionsspannung (u$_{i2}$) zu generieren, wobei die vorbezeichneten ersten und zweiten Induktionsspannungen entsprechend dem Induktionsgesetz (für Bewegungsinduktion):

$$u_{i1} = \frac{d\Psi 1}{dt} \sim \Psi 1 \cdot 2\pi \cdot f_N \cdot \cos\left(2\pi \cdot f_N \cdot t\right) \sim N1 \cdot \Phi 1 \cdot 2\pi \cdot f_N \cdot \cos\left(2\pi \cdot f_N \cdot t\right) \rightarrow s1 \quad \text{bzw.}$$

$$u_{i2} = \frac{d\Psi 2}{dt} \sim \Psi 2 \cdot 2\pi \cdot f_N \cdot \cos(2\pi \cdot f_N \cdot t) \sim N2 \cdot \Phi 2 \cdot 2\pi \cdot f_N \cdot \cos(2\pi \cdot f_N \cdot t) \rightarrow s2$$

jeweils von einem jeweiligen Verkettungs- bzw. Induktionsfluß ($\Psi 1 = N1 \cdot \Phi 1$ bzw. $\Psi 2 = N2 \cdot \Phi 2$), nämlich einem gesamtem magnetischen Fluß innerhalb der jeweiligen ersten bzw. zweiten Luftspule, mithin vom jeweiligen magnetischen Fluß $\Phi 1$ bzw. $\Phi 2$ und einer jeweils zugehörigen Windungszahl (N1 bzw. N2) abhängig sind. Die vom Meßaufnehmer 10 generierten Schwingungssmeßsignale s1, s2 sind im weiteren Verlauf der Meßsystem-Elektronik ME, beispielsweise via elektrischer Verbindungsleitungen, zugeführt um dort, beispielsweise mittels digitaler Signalverarbeitung (DSV), entsprechend verarbeitet, beispielsweise nämlich vorverstärkt, gefiltert und digitalisiert und hernach entsprechend ausgewertet zu werden.

Die Schwingungssensoren 51, 52 sind nach einer weiteren Ausgestaltung der Erfindung zudem so angeordnet, daß im Falle einer Anregung der vorbezeichneten Coriolisschwingungen des wenigstens einen Vibrationselements 11 jede der Nutzkomponenten $s1_N$, $s2_N$ der Schwingungsmeßsignale s1 bzw. s2 zudem jeweils auch einen vom Massestrom m des durch den Meßaufnehmer 10 strömenden Meßstoff abhängigen, beispielsweise relativ zum Treibersignal e1 bzw. dessen Nutzkomponente $e1_N$ meßbaren, Phasenwinkel aufweist; dies im besonderen in der Weise, daß, wie auch in Fig. 3 angedeutet, zwischen der Nutzkomponente $s1_N$ des Schwingungssignals s1 und der Nutzkomponente $s2_N$ des Schwingungssignals s2 eine von nämlicher Massestrom m abhängige Phasendifferenz $\Delta\varphi 12$ ($\Delta\varphi 12 = f(m)$), nämlich eine Differenz zwischen dem Phasenwinkel der ersten Nutzkomponente $s1_N$ und dem Phasenwinkel der zweiten Nutzkomponente $s2_N$ existiert bzw. daß die Schwingungsmeßsignale s1, s2 einer Änderung des Massestroms des im Meßaufnehmer geführten Meßstoffs mit einer Änderung nämlicher Phasendifferenz $\Delta\varphi 12$ ($\Delta\varphi 12^*$) folgen. Die Schwingungssensoren 51, 52 können, wie derartigen Meßaufnehmern durchaus üblich bzw. auch in Fig. 2 angedeutet, dementsprechend beispielsweise jeweils im gleichen Abstand zu einem Massenschwerpunkt des wenigstens einen Vibrationselements 11, beispielsweise also zum Massenschwerpunkt des wenigstens einen Rohrs bzw. zum Massenschwerpunkt des wenigstens einen Verdrängerelements, positioniert sein, derart, daß in Strömungsrichtung gesehen der Schwingungssensors 51 einlaßseitig am wenigstens einen Vibrationselement 11 bzw. in dessen Nähe und der Schwingungssensor 52 auslaßseitig am wenigstens einen Vibrationselement 11 bzw. in dessen Nähe angeordnet sind. Zudem können die beiden Schwingungssensoren 51, 52 auch die einzigen dem Erfassen von Schwingungen des wenigstens einen Vibrationselement 11 dienlichen Schwingungssensoren sein, derart, daß der Meßaufnehmer außer nämlichen Schwingungssensoren 51, 52 keinen weiteren Schwingungssensor aufweist. Nach einer weiteren Ausgestaltung der Erfindung ist ferner vorgesehen, daß der Meßaufnehmer zum Erfassen einer Temperatur des Meßaufnehmers an einem Temperatur-Meßpunkt wenigstens einen Temperatursensor 71 aufweist, der eingerichtet ist, ein Temperaturmeßsignal, nämlich ein die Temperatur am Temperatur-Meßpunkt repräsentierendes Meßsignal, insb. mit einer von der Temperatur abhängigen elektrischen Spannung und/oder einem von der Temperatur abhängigen elektrischen Strom, bereitzustellen. Alternativ oder in Ergänzung kann der Meßaufnehmer beispielsweise auch wenigstens einen dem Erfassen von mechanischen Spannungen innerhalb der Meßaufnehmers dienlichen Dehnungssensor aufweisen.

Die Meßsystem-Elektronik ME ist, wie bereits erwähnt, außer für die Erzeugung des Treibersignals e1 ferner auch dafür vorgesehen bzw. eingerichtet, die Schwingungsmeßsignale s1, s2 zu empfangen und auszuwerten, nämlich anhand der Schwingungsmeßsignale s1, s2, beispielsweise nämlich anhand der vorbezeichneten Phasendifferenz $\Delta\varphi 12$ zwischen den ersten und zweiten Nutzkomponenten, den Massestrom repräsentierende Massestrom-Meßwerte zu ermitteln, beispielsweise nämlich auch in Form von Analogwerten und/oder in Form von Digitalwerten auszugeben. Nach einer weiteren Ausgestaltung der Erfindung ist die Meßsystem-Elektronik 20 dementsprechend ferner dafür eingerichtet, anhand der Schwingungsmeßsignale s1, s2 zunächst die Phasendifferenz $\Delta\varphi 12$ zu ermitteln. Zudem kann die Meßsystem-Elektronik ME auch eingerichtet sein, von wenigstens einem der anliegenden Schwingungsmeßsignale s1, s2 den jeweiligen vorbezeichnete Phasenwinkel von dessen jeweiliger Nutzkomponente $s1_N$, $s2_N$, beispielsweise relativ zum Treibersignal e1 bzw. dessen vorbezeichneter Nutzkomponente $e1_N$, zu ermitteln und/oder anhand wenigstens eines der Schwingungsmeßsignale s1, s2 die Nutzfrequenz $f_N$ zu ermitteln, beispielsweise auch im Betrieb zumindest eine Phasenfolge, nämlich eine Sequenz von den Phasenwinkel einer der ersten und zweiten Nutzkomponenten entsprechend quantifizierenden digitalen Phasenwerten und/oder eine Frequenzfolge, nämlich eine Sequenz von die Nutzfrequenz $f_N$ quantifizierenden digitalen Frequenzwerten zu generieren, derart, daß die Phasenfolge einem zeitlichen Verlauf des Phasenwinkel der entsprechenden Nutzkomponente bzw. die Frequenzfolge einem zeitlichen Verlauf der Nutzfrequenz entspricht. Die Ermittlung der Phasenwinkel bzw. die Generierung der vorbezeichneten Phasenfolge kann beispielsweise, wie bei Coriolis-Massedurchfluß-Meßgeräten durchaus üblich, mittels einer in der Meßsystem-Elektronik ME entsprechend durchgeführten Quadraturdemodulation (Q/I-Demodulation) des jeweiligen Schwingungsmeßsignals mit einem die Nutzfrequenz aufweisenden ersten harmonischen Referenzsignal (Q) und einem dazu um 90° phasenverschobenen zweiten harmonischen Referenzsignal (I) realisiert sein. Nicht zuletzt für den erwähnten Fall, daß die mittels Treibersignals e1 bewirkten Nutzschwingungen Resonanzschwingungen des wenigstens einen Vibrationselements 11 sind, kann die Nutzfrequenz $f_N$ der Schwingungsmeßsignale s1, s2 als Maß für die Dichte und/oder die Viskosität des Meßstoffs dienen und kann dementsprechend mittels der Meßsystem-Elektronik ME die Dichte und/oder die Viskosität basierend auf der vorbezeichneten Frequenzfolge ermittelt werden. Nicht zuletzt für den vorbezeichneten Fall, daß der Meßaufnehmer einen Temperatursensor 71 und/oder einen Dehnungssensor aufweist, ist die Meßsystem-Elektronik 20 nach einer weiteren Ausgestaltung der Erfindung ferner auch dafür eingerichtet, das vom Temperatursensor generierte Temperaturmeßsignal bzw. das vom Dehnungssensor generierte Dehnungsmeßsignal zu empfangen und zu verarbeiten, insb. nämlich zu digitalisieren und auszuwerten; dies beispielsweise derart, daß die Meßsystem-Elektronik ME anhand des wenigstens einen Temperaturmeßsignals eine Temperatur des Verdrängerelments und/oder ein Temperatur des Meßstoffs ermittelt.

Nach einer weiteren Ausgestaltung der Erfindung ist die Meßsystem-Elektronik ME ferner eingerichtet, anhand des Schwingungsmeßsignals s1 eine erste Nutzkomponentenfolge, nämlich eine Sequenz von die Amplitude $U1_{N1}$ der ersten Nutzkomponente $s1_N$ quantifizierenden digitalen Amplitudenwerten $U1_{N1}[m]$ ($m \in N$ - natürliche Zahlen) zu generieren und ist die Meßsystem-Elektronik zudem eingerichtet, anhand des Schwingungsmeßsignals s2 eine zweite Nutzkomponentenfolge, nämlich eine Sequenz von die Amplitude $U2_N$ der zweiten Nutzkomponente $s2_N$ quantifizierenden digitalen Amplitudenwerten $U2_{N1}[n]$ ($n \in N$) zu generieren, beispielsweise nämliche derart, daß die Amplitudenwerten $U1_{N1}[m]$ zu äquidistant aufeinanderfolgenden Zeitpunkten $t_m = m \cdot T_{s1}$, mithin mit einer Aktualisierungsrate $f_{s1} = 1 / (t_{m+1} - t_m) = 1 / T_{s1}$ bzw. die die Amplitudenwerten $U2_N[n]$ zu äquidistanten aufeinanderfolgenden Zeitpunkten $t_n = n \cdot T_{s2}$, mithin mit einer Aktualisierungsrate $f_{s2} = 1 / (t_{n+1} - t_n) = 1 / T_{s2}$ ermittelt, derart daß die erste Nutzkomponentenfolge einem zeitlichen Verlauf der Amplitude $U1_N$ der ersten Nutzkomponente $s1_N$ bzw. die zweite Nutzkomponentenfolge einem zeitlichen Verlauf der Amplitude $U2_{N1}$ der zweiten Nutzkomponente $s2_N$ zumindest näherungsweise entsprechen. Die vorbezeichneten Aktualisierungsraten $f_{s1}$, $f_{s2}$ können beispielsweise so gewählt sein, daß sie gleich groß sind ($f_{s1} = f_{s2}$) und/oder daß ein Amplitudenwert $U1_{N1}[m]$ jeweils im wesentlichen zeitlich zu einem korrespondierenden Amplitudenwert $U2_{N1}[n]$ ermittelt werden ($t_m = t_n$).

Zum Verarbeiten der vom Meßaufnehmer gelieferten Schwingungsmeßsignale s1, s2, ggf. auch des vorbezeichneten Temperatur- und/oder Dehnungsmeßsignals, beispielsweise nämlich auch zum Ermitteln der Massestrom-Meßwerte und ggf. auch zum Ermitteln der Dichte-Meßwerte und/oder der Viskositäts-Meßwerte, kann die Meßsystem-Elektronik ME, wie bereits angedeutet, ferner eine entsprechende Meß- und Steuerelektronik DSV aufweisen, die, wie in Fig. 2 schematisch dargestellt, mit dem Meßaufnehmer 10 bzw. dessen Schwingungssensoren 51, 52 elektrisch verbunden ist, beispielsweise derart, daß von der Meß- und Steuerelektronik DSV ein erster Meßsignaleingang der Meßsystem-Elektronik ME für das Schwingungsmeßsignal s1 sowie wenigstens ein zweiter Meßsignaleingang der Meßsystem-Elektronik 20 für das Schwingungsmeßsignal s2 gebildet sind. Die Meß- und Steuerelektronik DSV kann vorteilhaft dafür eingerichtet sein, die zugeführten Schwingungsmeßsignale s1, s2, und ggf. auch die Temperatur- und/oder Dehnungsmeßsignale digital zu verarbeiten, beispielsweise nämlich mittels wenigstens einem Mikroprozessor und/oder wenigstens einem digitalen Signalprozessor (DSP) und/oder mittels eines programmierbaren Logikbausteins (FPGA) und/oder mittels eines kundenspezifisch programmierten Logikbausteins (ASIC) gebildet sein. Die im Betrieb des Meßsystems in einem oder mehreren der vorbezeichneten Mikroprozessoren bzw. digitalen Signalprozessoren der Meßsystem-Elektronik ME ausgeführten Programm-Codes können jeweils z.B. in einem oder mehreren nicht flüchtigen Datenspeichern (EEPROM) der Meßsystem-Elektronik ME persistent gespeichert sein und beim Starten derselben in einen in der Meßsystem-Elektronik ME bzw. der Meß- und Steuerelektronik DSV vorgesehenen, z.B. im Mikroprozessor integrierten, flüchtigen Datenspeicher (RAM) geladen werden. Die Schwingungsmeßsignale s1, s2 sind für eine Verarbeitung im Mikroprozessor bzw. im digitalen Signalprozessor mittels entsprechender Analog-zu-digital-Wandler (A/D) selbstverständlich zunächst in entsprechende Digitalsignale umzuwandeln, beispielsweise nämlich indem die jeweilige Signalspannung der Schwingungsmeßsignale s1, s2 digitalisiert wird, vgl. hierzu beispielsweise die eingangs erwähnten US-B 63 11 136 oder US-A 2011/0271756. Dementsprechend ist nach einer weiteren Ausgestaltung der Erfindung in der Meßsystem-Elektronik ME, beispielsweise nämlich in der vorbezeichneten Meß- und Steuerelektronik DSV, ein erster Analog-zu-Digital-Wandler für das Schwingungsmeßsignal s1 sowie ein zweiter Analog-zu-Digital-Wandler für das Schwingungsmeßsignal s2 und/oder ist in der in der Meßsystem-Elektronik ME wenigstens ein nicht flüchtiger elektronischer Datenspeicher EEPROM vorgesehen, der dafür eingerichtet ist, digitale Daten, beispielsweise nämlich auch ohne eine angelegte Betriebsspannung, vorzuhalten. Mittels der Meß- und Steuerelektronik DSV kann zudem auch die vorbezeichnete Phasenfolge und/oder die vorbezeichnete Frequenzfolge generiert werden, beispielsweise nämlich auch an einem entsprechenden digitalen Phasenausgang bzw. an einem entsprechenden digitalen Frequenzausgang ausgeben und so für eine weitere Verarbeitung in der Meßsystem-Elektronik ME bereitgestellt werden. Für den Fall, daß die Meßsystem-Elektronik ME mittels der vorbezeichnete Antriebselektronik Exc sowie mittels der vorbezeichneten Meß- und Steuerelektronik DSV gebildet ist, kann deren Phasenausgang mit einem Phaseneingang eines in der Antriebselektronik Exc vorgesehenen, beispielsweise auch einen Bestandteil der vorbezeichneten

Phasenregelschleife (PLL) bildenden, Phasenkomparators elektrisch verbunden sein und kann zudem nämlicher Phasenkomparator eingerichtet sein, eine anhand der Phasenfolge eine Phasendifferenz zwischen der vorbezeichneter Signalkomponente $e1_N$ des Treibersignals e1 und wenigstens einer der Nutzkomponenten $s1_N$, $s2_N$ festzustellen und/oder ein Ausmaß nämlicher Phasendifferenz zu ermitteln. Nach einer weiteren Ausgestaltung der Erfindung ist die Meß- und Steuerelektronik DSV ferner auch dafür eingerichtet, die vorbezeichneten ersten und zweiten Nutzkomponentenfolgen zu erzeugen und zumindest eine der Nutzkomponentenfolgen an einem digitalen Amplitudenausgang auszugeben. Der vorbezeichnete Amplitudenausgang der Meß- und Steuerelektronik DSV kann ferner beispielswiese auch mit einem eine Amplitude der Schwingungen des wenigstens einen Vibrationselements 11 erfassenden Amplitudeneingang der Antriebselektronik Exc elektrisch verbunden sein und die Antriebselektronik Exc kann zudem dafür eingerichtet sein, basierend auf der Amplitudenfolge das Treibersignal e1 so zu generieren, daß die Schwingungen des wenigstens einen Vibrationselements bzw. dessen Nutzschwingungen eine dafür vorgegeben Schwingungsamplitude erreichen bzw. nicht dauerhaft über- oder unterschreiten.

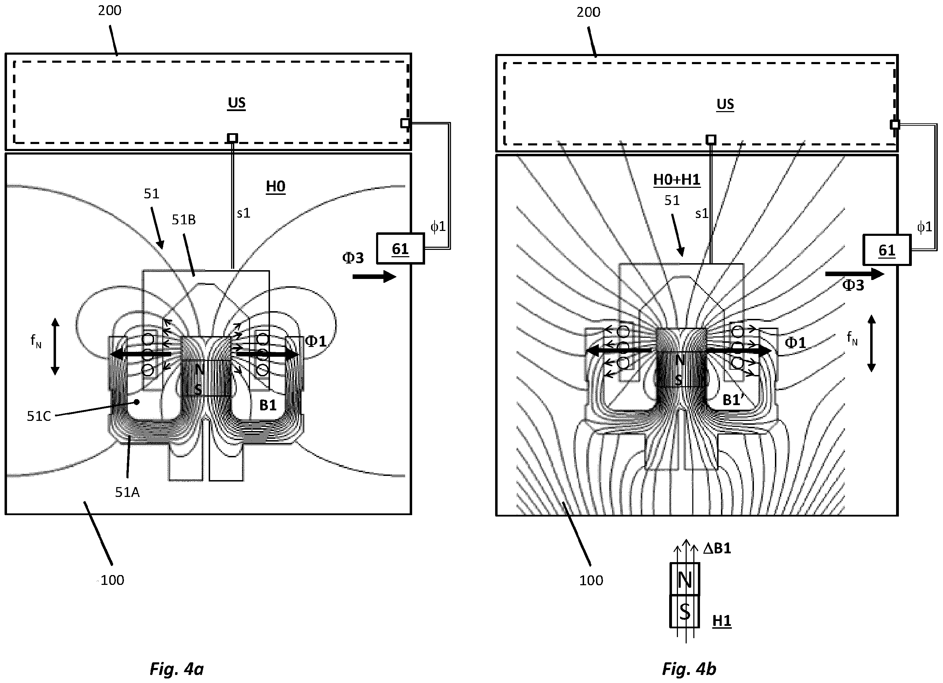

Wie bereits erwähnt, sind die Nutzkomponenten der beiden Schwingungsmeßsignale s1, s2 bzw. deren Amplituden, bedingt durch das Wirkprinzip der beiden elektrodynamischen Schwingungssensoren, von der zeitlichen Änderung des jeweiligen magnetischen Flusses innerhalb des Schwingungssensors, im Falle einer Tauchspule als Schwingungssensor nämlich des Verkettungs- bzw. Induktionsflusses innerhalb der jeweiligen Luftspule, abhängig; dies im besonderen auch in der Weise, daß eine von außerhalb des Meßsystems während dessen Meßbetriebs bewirkte zusätzliche Beeinflussung des bekannten inneren Magnetfeldes H0 bzw. eine damit einhergehende Beeinflussung eines bekannten, nämlich durch die vorbezeichnete Kalibrierung ermittelten Änderungsverhaltens ($\Delta\Phi1/\Delta t$, $\Delta\Phi2/\Delta t$) des magnetischen Flusses innerhalb des ersten und/oder zweiten Schwingungssensors, nicht zuletzt auch ein Änderungsverhalten ($\Delta\Phi1$, $\Delta\Phi2$) des magnetischen Flusses $\Phi1$ bzw. $\Phi2$ pro Schwingungsperiode der Nutzschwingungen, durch ein externes, nämlich von außerhalb des Meßsystems verursachtes, gleichwohl sich auch innerhalb des Meßsystems ausbreitendes Magnetfeld H1 eine unerwünschte, beispielsweise nämlich zu erhöhten Fehlern bei der Messung des Massestroms führenden, Beeinflussung der ersten und/oder zweiten Nutzkomponente, mithin eine Beeinträchtigung der Funktionstüchtigkeit des Meßaufnehmers bewirken kann. Ursachen für ein solches, ggf. auch über einen längeren Zeitraum konstantes, externes Magnetfeld H1 kann beispielsweise ein in der Nähe des jeweiligen Meßsystems erzeugtes elektrisches Feld sein, etwa auf Grund von in der Nähe des Meßsystems betriebene Elektromotoren, Transformatoren, Wechselrichter oder hohe elektrische (Gleich-)Ströme führende Anlagenteilen, wie z.B. Stromschienen, und/oder kann - wie auch in Fig. 4b angedeutet - ein außerhalb des jeweiligen Meßsystems bzw. in dessen Nähe positionierter Magnet, beispielsweise ein Elektromagnet oder ein Permanentmagnet, sein. Im Falle von Tauchspulen als Schwingungssensoren ist das vorbezeichnete innere Magnetfeld H0 jeweils im wesentlichen durch deren jeweilige Permanentmagneten bzw. das vorbezeichnete Änderungsverhalten des magnetischen Flusses im wesentlichen durch die den Schwingungsbewegungen des wenigstens einen Vibrationselements entsprechenden Bewegungen des jeweiligen Permanentmagneten im zugehörigen Luftspalt bestimmt und kann das externe Magentfeld H1 dazu führen, daß zumindest eine der dem inneren Magnetfeld H0 entsprechenden vorbezeichneten Flußdichten (B1 bzw. B2) des jeweiligen magnetischen Flusses $\Phi1$ bzw. $\Phi2$ verändert wird (B1 -> B1' = B1 + $\Delta$B1, B1 -> B2' = B2 + $\Delta$B2). Eine solche unerwünschte Beeinflussung der ersten und/oder zweiten Nutzkomponente $s1_N$, $s2_N$ bzw. Beeinträchtigung der Funktionstüchtigkeit des Meßaufnehmers durch ein externes Magnetfeld H1 kann beispielsweise auch darin bestehen, daß - wie auch in Fig. 3 angedeutet - zumindest eine der Nutzkomponenten eine zusätzliche frequenzgleiche Störkomponente ($S1_{N,Err}$, $S2_{N,Err}$) enthält, derart, daß der vorbezeichnete Phasenwinkel nämlicher Nutzkomponente, mithin auch die vorbezeichnete Phasendifferenz $\Delta\varphi12$ ($\Delta\varphi12$ -> $\Delta\varphi12_{Err}$) dann einen Phasenfehler, nämlich einen vom externen Magnetfeld H1 bzw. dessen Einfluß auf den im jeweiligen Schwingungssensor letztlich etablierten magnetischen Fluß abhängig Anteil aufweist; dies beispielsweise auch derart, daß die Integrität zumindest eines der Schwingungsmeßsignale bzw. der Massestrom-Meßwerte inakzeptabel herabgesetzt ist bzw. daß nämlicher Phasenfehler eine Meßgenauigkeit, mit der die Meßsystem-Elektronik 20 die Massestrom-Meßwerte dann ermittelt aus einem für das Meßsystem spezifizierten Toleranzbereich führt.

Um ein möglichst zeitnahes, gleichwohl präzises Detektieren eines - ggf. die Funktionstüchtigkeit des Meßaufnehmers beeinträchtigenden bzw. einen außerhalb einer Spezifikation des Meßsystems liegenden erhöhten Meßfehlers provozierenden - externen Magnetfeldes H1 zu ermöglichen, weist das erfindungsgemäße Meßsystem - wie auch in Fig. 4a und 4b schematisch dargestellt - ferner wenigstens einen dem Erfassen eines - hier sich insbesondere nämlich durch Überlagerung des internen Magnetfeldes H0 und des externen Magnetfeldes H1 ergebenden - innerhalb des Meßsystems, gleichwohl zumindest anteilig auch außerhalb der Schwingungssensoren 51, 52 etablierten Magnetfeldes H0 + H1 dienlichen ersten Magnetfelddetektor 61 auf. Beim erfindungsgemäßen Meßsystem ist der Magnetfelddetektor 61 im besonderen außerhalb des Aufnehmer-Gehäuses 100 positioniert; dies im besonderen auch derart, daß der Magnetfelddetektor 61 auch außerhalb des vorbezeichneten Elektronik-Gehäuses 200 positioniert ist. Der Magnetfelddetektor 61 kann dafür beispielsweise außen am Aufnehmer-Gehäuse 100 angebracht, insb. nämlich auch direkt am Aufnehmer-Gehäuse fixiert sein. Nach einer weiteren Ausgestaltung der Erfindung ist ferner vorgesehen, daß der Magnetfelddetektor 61 in der Nähe des Schwingungssensors 51, beispielsweise auch weniger als 5 cm davon entfernt, positioniert ist. Der Magnetfelddetektor 61 ist im besonderen eingerichtet, Änderungen des Magnetfeldes H0 + H1 an einem durch den Magnetfelddetektor 61 gebildeten, sowohl vom vorbezeichneten ersten Meßpunkt als auch vom vorbezeichneten zweiten Meßpunkt entfernten dritten Meßpunkt in ein, beispielsweise elektrisches, erstes Magnetfeldsignal $\phi1$ zu wandeln, das eine von einem - hier sowohl außerhalb des Schwingungssensors 51 als auch außerhalb des Schwingungssensors 52 etablierten - dritten magnetischen Fluß $\Phi3$, nämlich einem magnetischen Fluß durch den Magnetfelddetektor 61 und/oder von einer Flächendichte B3 nämlichen magnetischen Flusses Φ3 abhängige Amplitude U3 aufweist; dies im besonderen in der Weise, daß das Magnetfeldsignal φ1 auf zumindest eine Änderung des magnetischen Flusses Φ3 und/oder dessen Flächendichte B3 mit einer Änderung der Amplitude U3 folgt. Der Magnetfelddetektor 61 kann beispielsweise mittels wenigstens eines Hall-Sensors und/oder mittels wenigstens eines Reedschalter gebildet sein.

Der Magnetfelddetektor ist desweiteren über, insb. außen am Aufnehmer-Gehäuse entlang geführte, Anschlußleitungen elektrisch mit der Meßsystem-Elektronik 20 elektrisch verbunden. Wie in Fig. 2 angedeutet, können nämliche Anschlußleitungen beispielsweise auch mittels eines Verbindungskabels bereitgestellt und/oder zumindest abschnittsweise innerhalb eines außen an Aufnehmer- und/oder Elektronik-Gehäuse befestigten Schutzrohres bzw. Schutzschlauches verlegt sein. Beim erfindungsgemäßen Meßsystem ist zudem die die Meßsystem-Elektronik 20 auch dafür eingerichtet, anhand des Magnetfeldsignals φ1 zumindest qualitativ zu ermitteln, ob innerhalb des Meßaufnehmers - zusätzlich zum vorbezeichneten internen Magnetfeld H0 - auch das vorbezeichnete externe Magnetfeld H1 etabliert ist, beispielsweise nämlich zu ermitteln, ob eine, insb. eine Funktionstüchtigkeit des Meßaufnehmers vermindernde und/oder eine Fehlfunktion des Meßaufnehmers insgesamt bewirkende und/oder eine Integrität zumindest eines der ersten und zweiten Schwingungsmeßsignale bzw. der Massestrom-Meßwerte herabsetzende, Störung des Meßaufnehmers durch nämliches externes Magnetfeld H1 vorliegt.

Das Magnetfeldsignal φ1 kann beispielsweise ein das vorbezeichnete Magnetfeld H0 + H1 bzw. dessen Veränderungen lediglich qualitativ bewertendes bzw. lediglich in begrenztem Umfang diskrete Werte annehmendes Signal, beispielweise nämlich auch ein nominell lediglich zwei Zustände aufweisendes binäres Schaltsignal, sein. Das Magnetfeldsignal φ1 kann aber beispielsweise auch ein das Magnetfeld H0 + H1 bzw. dessen Änderungen wert- und zeitkontinuierlich quantifizierendendes Analogsignal sein, beispielsweise nämlich eine analoges elektrisches Signal mit einer vom magnetischen Fluß Φ3 und/oder von dessen Flächendichte B3 abhängigen elektrischen Spannung. Nicht zuletzt für den vorbeschriebenen Fall, daß das Magnetfeldsignal φ1 als ein Analogsignal ausgebildet ist, ist die Meßsystem-Elektronik 20 nach einer weiteren Ausgestaltung der Erfindung ferner auch dafür eingerichtet, anhand des wenigstens einen Magnetfeldsignals zumindest gelegentlich auch einen oder mehrere Kennzahlenwerte für wenigstens eine - beispielsweise nämlich eine Beeinflussung des Meßaufnehmers durch das externe Magnetfeld und/oder eine Beeinflussung zumindest eines der magnetischen Flüsse Φ1, Φ2 charakterisierende - Magnetfeld-Kennzahl MK1 zu berechnen, derart, daß nämliche Magnetfeld-Kennzahl MK1; dies insb. derart, daß nämliche Magnetfeld-Kennzahl MK1 von einer Abweichung des magnetischen Flusses Φ1 vom magnetischen Fluß Φ2 abhängig ist und/oder nämliche Abweichung bewertet und/oder quantifiziert; alternativ nämliche

Magnetfeld-Kennzahl MK1 auch so gewählt bzw. können so berechnet werden, daß die Magnetfeld-Kennzahl MK1 von einer Abweichung des magnetischen Flusses Φ3 von einem vorab ermittelten Bezugswert und damit indirekt auch von einer Abweichung zumindest des magnetischen Flusses Φ1 vom Bezugswert abhängig ist und/oder nämliche Abweichung bewertet und/oder quantifiziert, für die Sensoren-Kennzahl MK1 beispielsweise also gilt:

$$MK1 = f(U3) = f(\Phi3(\Phi1)) = f(H0, H1) \tag{1}$$

Die Magnetfeld-Kennzahl MK1 kann im Betrieb des Coriolis-Massedurchfluß-Meßgeräts wiederkehrend mittels der Meßsystem-Elektronik ME ermittelt werden, beispielsweise anhand von für die Amplitude U3 des Magnetfeldsignals φ1 ermittelte digitale Amplitudenwerte. Für den erwähnten Fall, daß in der Meßsystem-Elektronik ME wenigstens ein nicht flüchtiger elektronischer Datenspeicher EEPROM vorgesehen ist kann die Meßsystem-Elektronik ME zudem dafür eingerichtet sein, eingerichtet sein, einen oder mehrere der vorbezeichneten digitalen Amplitudenwerte für die Amplitude U3 in nämlichem Datenspeicher EEPROM zu speichern, beispielsweise auch jeweils zusammen mit einem Zahlenwert für eine einen jeweiligen Zeitpunkt des Ermittelns des jeweiligen Kennzahlenwerts entsprechenden Zeitvariable (Zeitstempel).

Zum Detektieren des Vorliegens eines die Funktionstüchtigkeit des Meßaufnehmers, mithin die Meßgenauigkeit des Meßsystems beeinträchtigenden externen Magnetfeldes H1 ist die Meßsystem-Elektronik 20 gemäß einer weiteren Ausgestaltung der Erfindung ferner eingerichtet, einen oder mehrere Kennzahlenwerte für die wenigstens eine Magnetfeld-Kennzahl MK1 auszuwerten, beispielsweise nämlich jeweils mit einem oder mehreren für die nämliche Magnetfeld-Kennzahl MK1 vorab ermittelten, beispielsweise nämlich in vorbezeichnetem nicht flüchtigen elektronischen Datenspeicher EEPROM gespeicherten, Bezugswerten BK1$_1$ (BK1$_1$, BK1$_2$,... BK1$_i$...) zu vergleichen. Dementsprechend ist die Meßsystem-Elektronik ME ferner auch dafür eingerichtet, zu ermitteln, ob ein oder mehrere Kennzahlenwerte für die Magnetfeld-Kennzahl MK1 größer als einer oder mehrere solcher, beispielsweise nämlich ein nicht mehr intaktes Meßsystems repräsentierende, Bezugswerte für die Magnetfeld-Kennzahl MK1 ist und ggf. beispielsweise auch eine dies signalisierende (Störungs-)Meldung auszugeben, beispielsweise nämlich vor Ort anzuzeigen und/oder als Statusmeldung an das vorbezeichnete elektronischen Datenverarbeitungssystem zu übermitteln. Bei den vorbezeichneten Bezugswerten für die Magnetfeld-Kennzahl MK1 kann es sich beispielsweise um eine (auf ein externes Magnetfeld zurückzuführende) verminderte Funktionstüchtigkeit des Meßaufnehmers bzw. eine (auf ein externes Magnetfeld zurückzuführende) Fehlfunktion des Meßaufnehmers repräsentierende Bezugswerte handeln. Nämliche Bezugswerte können beispielsweise vorab, beispielsweise nämlich vom Hersteller des Meßsystems bzw. bei einer während der Herstellung des Meßsystems vollzogenen (Werks-)Kalibrierung und/oder während der Inbetriebnahme vor Ort, und/oder im Betrieb des Meßsystems ermittelt werden; dies beispielsweise, derart, daß zunächst die jeweilige Magnetfeld-Kennzahl $MK1$ für das fertiggestellte, mithin intakte Meßsystem ermittelt und mit einem einer noch tolerierbaren Beeinflussung entsprechenden Toleranzwert entsprechend in den Bezugswert $BK1_1$ umgerechnet wird und/oder indem die Magnetfeld-Kennzahl $MK1$ mittels des in der Nähe eines ein Referenz-Magnetfeld bewirkenden Magneten positionierten, ansonsten aber intakten Meßsystems direkt ermittelt und als Bezugswert $BK1_1$ im Datenspeicher EEPROM abgespeichert wird.

Die Ermittlung der Kennzahlenwerte $MK1$ bzw. das Ermitteln des Vorliegens eines externen Magnetfeldes kann beispielsweise automatisiert, beispielsweise nämlich zeitgesteuert und/oder auch in Abhängigkeit von Änderungen von anderen Diagnosewerten, initiiert bzw. wieder ausgesetzt werden. Alternativ oder in Ergänzung kann die Ermittlung der Kennzahlenwerte aber auch von extern des Meßsystems initiiert und/oder ausgesetzt werden, beispielsweise nämlich ausgehend von vorbezeichnetem elektronischen Datenverarbeitungssystem über die vorbezeichnete Sende- und Empfangselektronik COM und/oder ausgehend von Bedienpersonal vor Ort über die vorbezeichnete Anzeige- und Bedienelement HMI. Dementsprechend ist die Meßsystem-Elektronik 20 nach einer weiteren eingerichtet ist, einen zumindest die Ermittlung der Kennzahlenwerte für zumindest die Magnetfeld-Kennzahl $MK1$, ggf. nämlich auch deren vorbezeichnete Auswertung initiierenden Start-Befehl zu empfangen und auszuwerten, nämlich einen Eingang des Start-Befehls zu detektieren und daraufhin eine Ermittlung der Kennzahlenwerte für die erste Magnetfeld-Kennzahl $MK1$ in Gang zu setzen und/oder ist die Meßsystem-Elektronik eingerichtet, einen die Ermittlung der Kennzahlenwerte für die Magnetfeld-Kennzahl $MK1$ zumindest vorübergehend unterbindenden Stop-Befehl zu empfangen und auszuwerten, nämlich einen Eingang des Stop-Befehls zu detektieren und daraufhin eine Ermittlung der Kennzahlenwerte für die erste Magnetfeld-Kennzahl $MK1$ zumindest vorübergehend anzuhalten.

Für den vorbezeichneten Fall, daß die Meßsystem-Elektronik ME mittels zweier Elektronik-Module ME1, ME2 gebildet ist, kann das Elektronik-Modul ME1 beispielsweise eingerichtet sein, sowohl das vorbezeichnete Treibersignal e1 zu generieren als auch die Schwingungsmeßsignale s1, s2 zu empfangen und auszuwerten, und kann das Elektronik-Modul ME2 beispielsweise eingerichtet sein, daß Magnetfeldsignal $\phi1$ zu empfangen und auszuwerten, beispielsweise nämlich die vorbezeichnete Magnetfeld-Kennzahl $MK1$ zu berechnen und/oder mit den vorbezeichneten Bezugswerten $BK1_1$ entsprechend zu vergleichen und/oder die vorbezeichnete (Störungs-)Meldung zu generieren. Zudem kann ein Signalausgang des Elektronik-Moduls ME2 mit einem korrespondierenden Signaleingang des Elektronik-Moduls ME1 elektrisch verbunden sein und kann das Elektronik-Modul ME2 eingerichtet sein die vorbezeichnete (Störungs-)Meldung an das Elektronik-Modul ME1 zu übermitteln. Alternativ oder in Ergänzung kann das das Elektronik-Modul ME2 dafür eingerichtet sein, vom Elektronik-Modul ME1 ermittelte Meßwerte zu empfangen und an einem Signalausgang entsprechend auszugeben, beispielsweise derart, keine Meßwerte, insb. keine Massenstrom-Meßwerte, ausgegeben werden, falls eine Störung durch das externe Magnetfeld H1 vorliegt, bzw. daß Massenstrom-Meßwerte allenfalls als qualifizierte Meßwerte des Meßsystems ausgegeben werden, falls keine derartige Störung vorliegt. Nach einer weiteren Ausgestaltung ist die Meßsystem-Elektronik 20 ferner dafür eingerichtet, die Funktionstüchtigkeit auch des Magnetfelddetektors 61 selbst zu überwachen, beispielsweise unter Auswertung des Magnetfeldsignal $\phi1$; dies im besonderen in der Weise, daß Meßsystem-Elektronik ME anhand des Magnetfeldsignal $\phi1$ und/oder anhand einer Messung eines elektrischen Widerstandes und/oder einer elektrischen Impedanz der den Magnetfelddetektor 61 und die Meßsystem-Elektronik ME elektrisch verbindenden Anschlußleitungen überprüft, ob Magnetfelddetektor 61 und Meßsystem-Elektronik ME nach wie vor elektrisch miteinander verbunden sind.

Zum Schutz des wenigstens einen Magnetfelddetektors 61 vor störenden oder schädlichen Umwelteinflüssen bzw. zur Reduzierung oder Vermeidung umweltbedingter Störungen des Magnetfelddetektors 61 umfaßt das Meßsystem nach einer weiteren Ausgestaltung der Erfindung einen, beispielsweise aus einem Edelstahl, etwa 1.4404 (St 316L) bestehenden, Schutz-Schild 300 für den wenigstens einen Magnetfelddetektor. Nämlicher Schutz-Schild 300 ist, wie auch in Fig. 2 schematisch dargestellt, außerhalb des Aufnehmer-Gehäuses 100 unter Bildung eines zwischen Schutz-Schild und Aufnehmer-Gehäuse 100 verorteten, für die Unterbringung zumindest des Magnetfelddetektors 61 geeigneten Zwischenraums 300* positioniert und der Magnetfelddetektor 61 ist dann innerhalb des Zwischenraums positioniert. Der Schutz-Schild 300 kann beispielsweise außen am Aufnehmer-Gehäuse 100 angebracht sein, beispielsweise nämlich damit stoffschlüssig verbunden, insb. nämlich damit verschweißt sein. Der Schutz-Schild 300 kann aber auch wieder lösbar mit dem Aufnehmer-Gehäuse 100 verbunden, beispielsweise nämlich daran angeschraubt und/oder auf das Aufnehmer-Gehäuse 100 aufgeschnallt sein. Alternativ oder in Ergänzung kann der Schutz-Schild 300 auch am vorbezeichneten Elektronik-Gehäuse 200 angebracht sein. Vorteilhaft kann der Schutz-Schild 300 beispielsweise auch eingerichtet bzw. ausgestaltet sein, den Meßaufnehmer bzw. sowohl den Meßaufnehmer MW als auch den Magnetfelddetektor gegen das externe Magnetfeld H1 zu schirmen. Dafür kann der Schutz-Schild 300 zumindest teilweise auch aus einem ferromagnetischen Material, beispielsweise einem ferritischen Stahl, bestehen. Nicht zuletzt für den vorbezeichneten Fall, daß der Schutz-Schild mit dem Aufnehmer-Gehäuse 100 und/oder dem Elektronik-Gehäuse 200 wiederlösbar verbunden ist, ist nach einer weiteren Ausgestaltung Schutz-Schild 300 mittels wenigstens einer Plombe am Aufnehmer-Gehäuse bzw. am Elektronik-Gehäuse gesichert, beispielsweise nämlich gegen nicht autorisiertes Entfernen.

Um die Genauigkeit bzw. Verläßlichkeit mit der die Anwesenheit des externe Magnetfeldes festgestellt werden kann weiter zu erhöhen ist nach einer weiteren Ausgestaltung der Erfindung vorgesehen, daß das Meßsystem zum Erfassen des Magnetfeldes - wie auch in Fig. 2. bzw. 5a und 5b jeweils angedeutet bzw. auch aus deren Zusammenschau ohne weiteres ersichtlich - wenigstens einen, beispielsweise auch zum Magnetfelddetektor 61 baugleichen, zweiten Magnetfelddetektor 62 aufweist, der eingerichtet ist, Änderungen des Magnetfeldes H0 bzw. H0+H1 an einem vom vorbezeichneten dritten Meßpunkt entfernten, beispielsweise nämlich auch vom ersten Meßpunkt und/oder vom zweiten Meßpunkten entfernten, vierten Meßpunkt in ein, insb. nämliche Änderungen des Magnetfeldes bewertendes und/oder die Änderungen quantifizierendendes und/oder elektrisches, zweites Magnetfeldsignal $\phi2$ zu wandeln, das eine von einem vierten magnetischen Fluß $\Phi4$, nämlich einem magnetischen Fluß durch den Magnetfelddetektor 62 und/oder von einer Flächendichte B4 nämlichen magnetischen Flusses $\Phi4$ abhängige Amplitude U4 aufweist, derart, daß das Magnetfeldsignal $\phi2$ auf zumindest eine Änderung des vierten magnetischen Flusses $\Phi4$ und/oder dessen Flächendichte B4 mit einer Änderung der Amplitude U4 folgt. Darüberhinaus ist die Meßsystem-Elektronik 20 zudem eingerichtet, auch das Magnetfeldsignal $\phi2$ zu empfangen und auszuwerten, nämlich anhand auch des Magnetfeldsignals $\phi2$ zu ermitteln, ob das externe Magnetfeld H1 vorliegt. Das Magnetfeldsignal $\phi2$ kann aber auch als ein Analogsignal ausgebildet sein, beispielsweise mit einer vom magnetischen Fluß $\Phi4$ und/oder von dessen Flächendichte B4 abhängigen elektrischen Spannung. Dementsprechend kann der Magnetfelddetektor 62 mittels eines Hall-Sensors und/oder eines Reedschalters gebildeten sein. Nach einer weiteren Ausgestaltung der Erfindung ist zudem vorgesehen, daß auch der Magnetfelddetektor 62 außerhalb des Aufnehmer-Gehäuses 100 positioniert ist, beispielsweise nämlich außen am Aufnehmer-Gehäuse 100 angebracht ist. Zudem kann der Magnetfelddetektor 62 beispielsweise in der Nähe des Schwingungssensors 52, insb. nämlich weniger als 5 cm und/oder weniger weit entfernt vom Schwingungssensor 52 als vom Schwingungssensor 51, positioniert sein. Alternativ oder in Ergänzung kann der Magnetfelddetektor 62 beispielsweise auch weniger weit entfernt vom Schwingungssensor 51 als vom Schwingungssensor 52 positioniert sein. Für den vorbezeichneten Fall, daß das Meßsystem einen Schutz-Schild aufweist, kann der Magnetfelddetektor 62 beispielsweise auch neben dem Magnetfeldetektor 61 im Zwischenraum positioniert sein. Falls erforderlich, kann das Meßsystem darüberhinaus auch weitere Magnetfeldetektoren aufweisen, beispielsweise derart, daß Magnetfeldetektoren sowohl vorder- als auch rückseitig des Aufnehmer-Gehäuses und/oder sowohl links- als auch rechtsseitig des Aufnehmer-Gehäuses /oder sowohl ober- als auch unterseitig des Aufnehmer-Gehäuses positioniert sind bzw. derart, daß an wenigstens zwei einander gegenüberliegenden Seiten des Meßaufnehmers bzw. dessen Aufnehmer-Gehäuses jeweils mindestens ein Magnetfeldetektor, beispielsweise nämlich jeweils zwei oder mehr und/oder jeweils gleich viele Magnetfeldetektoren angeordnet sind.

## Patentansprüche

1. Vibronisches Meßsystem, insb. Coriolis-Massedurchfluß-Meßgerät oder Coriolis-Massedurchfluß-/Dichte-Meßgerät, zum Messen eines Massestroms eines fluiden Meßstoffs - insb. eines Gases, einer Flüssigkeit oder einer Dispersion -, welches Meßsystem umfaßt:

   - einen Meßaufnehmer (MW),

      -- der wenigstens ein, insb. rohrförmiges, Vibrationselement (10), zum Anregen und Aufrechterhalten von mechanischen Schwingungen des wenigstens einen Vibrationselements (11) wenigstens einen Schwingungserreger sowie zum Erfassen mechanischer Schwingungen des wenigstens einen Vibrationselements, insb. dessen Nutzschwingungen, einen elektrodynamischen ersten Schwingungssensor (51) und wenigstens einen, insb. zum ersten Schwingungssensor (51) baugleichen, elektrodynamischen zweiten Schwingungssensor (52) aufweist und

      -- der eingerichtet ist, den Meßstoff zu führen, nämlich zumindest zeitweise vom Meßstoff durchströmt zu werden;

   - ein Aufnehmer-Gehäuse (100) für den Meßaufnehmer, insb. mit einer Wandung aus einem Metall;
   - zum Erfassen eines innerhalb des Meßsystems etablierten, insb. nämlich durch ein außerhalb des Aufnehmer-Gehäuses erzeugtes elektrisches Feld und/oder einen außerhalb des Aufnehmer-Gehäuses positionierten Magneten verursachten und/oder zeitliches konstanten, Magnetfeldes (H0+H1) wenigstens einen, insb. mittels eines Hall-Sensors und/oder eines Reedschalters gebildeten, ersten Magnetfelddetektor (61);
   - sowie eine sowohl mit dem Meßaufnehmer, nämlich mit dessen wenigstens einem Schwingungserreger und mit dessen ersten und zweiten Schwingungssensoren, als auch mit dem ersten Magnetfelddetektor (61) elektrisch gekoppelte, insb. mittels wenigstens eines Mikroprozessors gebildete und/oder modular aufgebaute, Meßsystem-Elektronik (ME);

- wobei der Meßaufnehmer innerhalb des Aufnehmer-Gehäuses (100) und der erste Magnetfelddetektor außerhalb des Aufnehmer-Gehäuses (100) positioniert ist, insb. derart, daß das wenigstens eine Vibrationselement (11) am Aufnehmer-Gehäuse (100) gehalten ist und/oder daß der erste Magnetfelddetektor außen am Aufnehmer-Gehäuse (100) angebracht ist;

- wobei das wenigstens eine Vibrationselement eingerichtet ist, vom strömenden Meßstoff kontaktiert und währenddessen vibrieren gelassen zu werden;

- wobei der wenigstens eine Schwingungserreger eingerichtet ist, dorthin eingespeiste elektrische Leistung in erzwungene mechanische Schwingungen des Vibrationselements bewirkende mechanische Leistung zu wandeln;

- wobei die Meßsystem-Elektronik eingerichtet ist, ein elektrisches Treibersignal (e1) zu generieren und damit elektrische Leistung in den wenigstens einen Schwingungserreger einzuspeisen, derart, daß das Vibrationselement zumindest anteilig Nutzschwingungen, nämlich erzwungene mechanische Schwingungen mit wenigstens einer Nutzfrequenz, nämlich einer durch das elektrische Treibersignal vorgegebenen, insb. einer Resonanzfrequenz des Meßaufnehmers entsprechenden, Schwingungsfrequenz ausführt, die geeignet sind, im strömendem Meßstoff vom Massestrom abhängige Corioliskräfte zu bewirken;

- wobei der erste Schwingungssensor (51) eingerichtet ist, Schwingungsbewegungen des wenigstens einen Vibrationselements an einem ersten Meßpunkt in ein elektrisches erstes Schwingungsmeßsignal (s1) des Meßaufnehmers zu wandeln, derart, daß nämliches erstes Schwingungsmeßsignal wenigstens eine erste Nutzkomponente ($s1_{N1}$), nämlich eine Wechselspannungskomponente

-- mit einer der Nutzfrequenz entsprechenden Frequenz,
-- und mit einer von der Nutzfrequenz und einem ersten magnetischen Fluß ($\Phi1$), nämlich einem magnetischen Fluß durch den ersten Schwingungssensor (51) abhängigen Amplitude ($U1_N$) aufweist;

- wobei der zweite Schwingungssensor (52) eingerichtet ist, Schwingungsbewegungen des wenigstens einen Vibrationselements an einem vom ersten Meßpunkt entfernten zweiten Meßpunkt in ein elektrisches zweites Schwingungsmeßsignal des Meßaufnehmers zu wandeln, derart, daß nämliches zweites Schwingungsmeßsignal wenigstens eine zweite Nutzkomponente ($s2_{N1}$), nämlich eine Wechselspannungskomponente

-- mit einer der Nutzfrequenz entsprechenden Frequenz,
-- und mit einer von der Nutzfrequenz und einem zweiten magnetischen Fluß ($\Phi2$), nämlich einem magnetischen Fluß durch den zweiten Schwingungssensor (52) abhängigen Amplitude aufweist;

- wobei der erste Magnetfelddetektor (61) eingerichtet ist, das Magnetfeld (H1) an einem außerhalb des Aufnehmer-Gehäuses (100) verorteten dritten Meßpunkt zu erfassen und in ein, insb. nämliches Magnetfeld (H1) bewertendes und/oder quantifizierendendes und/oder elektrisches, erstes Magnetfeldsignal ($\phi1$) zu wandeln, das eine von einem dritten magnetischen Fluß ($\Phi3$), nämlich einem magnetischen Fluß durch den ersten Magnetfelddetektor und/oder von einer Flächendichte (B3) nämlichen magnetischen Flusses ($\Phi3$) abhängige Amplitude (U3) aufweist, insb. derart, daß das erste Magnetfeldsignal zumindest einer Änderung des dritten magnetischen Flusses ($\Phi3$) und/oder dessen Flächendichte (B3) mit einer Änderung der Amplitude (U3) folgt;

- und wobei die Meßsystem-Elektronik (20) eingerichtet ist, sowohl die ersten und zweiten Schwingungsmeßsignale als auch zumindest das erste Magnetfeldsignal ($\phi1$) zu empfangen und auszuwerten, nämlich

-- anhand der ersten und zweiten Schwingungsmeßsignale den Massestrom repräsentierende, insb. digitale, Massestrom-Meßwerte zu ermitteln, insb. nämlich an einem Signalausgang auszugeben,
-- sowie anhand des ersten Magnetfeldsignals zumindest qualitativ zu ermitteln, ob und/oder inwieweit das Magnetfeld (H1) an den ersten und/oder zweiten Meßpunkten etabliert ist bzw. einen Beitrag zu den ersten und/oder zweiten magnetischen Flüssen ($\Phi1$, $\Phi2$) leistet, und/oder zu ermitteln, ob eine, insb. eine Funktionstüchtigkeit des Meßsystems vermindernde und/oder eine Fehlfunktion des Meßsystems bewirkende und/oder eine Integrität zumindest eines der ersten und zweiten Schwingungsmeßsignale bzw. der daraus gewonnenen Massestrom-Meßwerte herabsetzende, Störung des Meßsystems durch nämliches Magnetfeld (H1) vorliegt.

2. Vibronisches Meßsystem nach Anspruch 1, weiters umfassend: wenigstens ein, insb. modular aufgebautes, Elektronik-Gehäuse (200), wobei die Meßsystem-Elektronik zumindest teilweise, insb. vollständig, innerhalb des Elektronik-Gehäuses (200) untergebracht ist und/oder wobei der erste Magnetfelddetektor außerhalb des Elektronik-Gehäuses (200) positioniert ist.

3. Vibronisches Meßsystem nach dem vorherigen Anspruch, wobei das Aufnehmer-Gehäuse (100) einen Anschlußstutzen für das Elektronik-Gehäuse (200) aufweist, und wobei das Elektronik-Gehäuse (200) mit dem Anschlußstutzen, insb. wiederlösbar, mechanisch verbunden ist.

4. Vibronisches Meßsystem nach einem der vorherigen Ansprüche, weiters umfassend: einen, insb. metallischen, Schutz-Schild für den wenigstens einen Magnetfelddetektor, wobei der Schutz-Schild außerhalb des Aufnehmer-Gehäuses unter Bildung eines zwischen Schutz-Schild und Aufnehmer-Gehäuse verorteten Zwischenraums positioniert, insb. nämlich außen am Aufnehmer-Gehäuse angebracht, ist, und wobei der Magnetfelddetektor innerhalb nämlichen Zwischenraums positioniert ist.

5. Vibronisches Meßsystem nach dem vorherigen Anspruch,

   - wobei der Schutz-Schild zumindest teilweise aus einem Edelstahl besteht; und/oder
   - wobei der Schutz-Schild mit dem Aufnehmer-Gehäuse stoffschlüssig verbunden, insb. nämlich damit verschweißt, ist; und/oder
   - wobei der Schutz-Schild mittels wenigstens einer Plombe am Aufnehmer-Gehäuse gesichert ist.

6. Vibronisches Meßsystem nach einem der Ansprüche 2 bis 5, wobei das Elektronik-Gehäuse (200) modular ausgebildet ist, derart, daß das das Elektronik-Gehäuse (200) ein erstes Gehäuse-Modul (200A) und ein zweites Gehäuse-Modul (200B) aufweist, insb. derart, daß das erste Gehäuse-Modul (200A) außen am Aufnehmer-Gehäuse (100) angebracht ist und/oder daß das zweite Gehäuse-Modul (200B) außen am ersten Gehäuse-Modul (200A) angebracht ist.

7. Vibronisches Meßsystem nach einem der vorherigen Ansprüche, wobei die Meßsystem-Elektronik modular ausgebildet ist, derart daß die Meßsystem-Elektronik ein erstes Elektronik-Modul (ME1) und eine ein zweites Elektronik-Modul (ME2) aufweist.

8. Vibronisches Meßsystem nach Anspruch 6 und 7,

   - wobei das erste Gehäuse-Modul (200A) des Elektronik-Gehäuses (200) eingerichtet ist, das erste Elektronik-Modul (ME1) der Meßsystem-Elektronik (ME) aufzunehmen, und das zweite Gehäuse-Modul (200B) des Elektronik-Gehäuses (200) eingerichtet ist, das zweite Elektronik-Modul (ME2) der Meßsystem-Elektronik (ME) aufzunehmen;
   - und wobei das erste Elektronik-Modul (ME1) innerhalb des ersten Gehäuse-Moduls (200A) und das zweite Elektronik-Modul (ME2) innerhalb des zweiten Gehäuse-Moduls (200B) untergebracht ist.

9. Vibronisches Meßsystem nach Anspruch 7 oder 8,

   - wobei das erste Elektronik-Modul (ME1) der Meßsystem-Elektronik eingerichtet ist, sowohl das Treibersignal zu generieren als auch die ersten und zweiten Schwingungsmeßsignale zu empfangen und auszuwerten, und das zweites Elektronik-Modul (ME2) der Meßsystem-Elektronik eingerichtet ist das ersten Magnetfeldsignal zu empfangen und auszuwerten; und/oder.
   - wobei die ersten und zweiten Elektronik-Module (ME1, ME2) der Meßsystem-Elektronik elektrisch miteinander gekoppelt sind, insb. derart, daß das ein Signalausgang des ersten Elektronik-Moduls (ME1) mit einem Signaleingang des zweiten Elektronik-Moduls (ME2) elektrisch verbunden ist.

10. Vibronisches Meßsystem nach einem der vorherigen Ansprüche, wobei das erste Magnetfeldsignal ($\phi1$) ein, insb. werte- und zeitkontinuierliches, Analogsignal ist, insb. mit einer vom dritten magnetischen Fluß ($\Phi3$) und/oder von dessen Flächendichte (B3) abhängigen Spannung.

11. Vibronisches Meßsystem nach dem vorherigen Anspruch, wobei die Meßsystem-Elektronik eingerichtet ist, anhand des ersten Magnetfeldsignals Kennzahlenwerte für wenigstens eine, insb. eine Beeinflussung des Meßaufnehmers durch das externe Magnetfeld und/oder eine Beeinflussung zumindest eines der ersten und zweiten magnetischen Flüsse charakterisierende, Magnetfeld-Kennzahl (MK1) zu berechnen, insb. derart, daß nämliche Magnetfeld-Kennzahl von einer Abweichung des ersten magnetischen Flusses vom zweiten magnetischen Fluß abhängig ist und/oder nämliche Abweichung bewertet und/oder quantifiziert oder daß nämliche Magnetfeld-Kennzahl von einer Abweichung des ersten magnetischen Flusses von einem vorab ermittelten Bezugswert abhängig ist und/oder nämliche Abweichung bewertet und/oder quantifiziert.

12. Vibronisches Meßsystem nach einem der vorherigen Ansprüche,

- wobei die Meßsystem-Elektronik einen nicht-flüchtigen elektronischen Datenspeicher (EEPROM) aufweist, der dafür eingerichtet ist, digitale Daten, insb. auch ohne eine angelegte Betriebsspannung, vorzuhalten, insb. nämlich einen oder mehrere vorab ermittelte Bezugswerte für die Magnetfeld-Kennzahl zu speichern;
- und wobei im elektronischen Datenspeicher ein oder mehrere, insb. vom Hersteller des Meßsystem und/oder bei der Herstellung des Meßsystem und/oder im Betrieb des Meßsystem vorab ermittelte, Bezugswerte für die Magnetfeld-Kennzahl, insb. nämlich ein oder mehrere eine verminderte Funktionstüchtigkeit des Meßaufnehmers repräsentierende Bezugswerte und/oder nämlich ein oder mehrere eine Fehlfunktion des Meßaufnehmers repräsentierende Bezugswerte, gespeichert sind.

13. Vibronisches Meßsystem nach dem vorherigen Anspruch, wobei die Meßsystem-Elektronik eingerichtet ist, einen oder mehrere Kennzahlenwerte für die Magnetfeld-Kennzahl jeweils mit einem oder mehreren im Datenspeicher gespeicherten Bezugswerten für die Magnetfeld-Kennzahl zu vergleichen.

14. Vibronisches Meßsystem nach einem der vorherigen Ansprüche, wobei der erste Magnetfeldetektor weniger weit entfernt vom ersten Schwingungssensor (51) als vom zweiten Schwingungssensor (52) und/oder weniger als 5 cm vom ersten Schwingungssensor (51) entfernt positioniert ist.

15. Vibronisches Meßsystem nach einem der vorherigen Ansprüche, weiters umfassend: zum Erfassen des Magnetfeldes (H1) wenigstens einen, insb. mittels eines Hall-Sensors und/oder eines Reedschalters gebildeten und/oder zum ersten Magnetfelddetektor (61) baugleichen, zweiten Magnetfelddetektor (62),

- wobei der zweite Magnetfelddetektor (62) eingerichtet ist, das Magnetfeld (H1) an einem vom dritten Meßpunkt entfernten, insb. auch vom ersten Meßpunkt und/oder vom zweiten Meßpunkten entfernten und/oder außerhalb des Aufnehmer-Gehäuses (100) verorteten, vierten Meßpunkt zu erfassen und in ein, insb. das Magnetfeld (H1) bewertendes und/oder quantifizierendendes und/oder elektrisches, zweites Magnetfeldsignal ($\phi$2) zu wandeln, das eine von einem vierten magnetischen Fluß ($\Phi$4), nämlich einem magnetischen Fluß durch den zweiten Magnetfelddetektor und/oder von einer Flächendichte (B4) nämlichen magnetischen Flusses ($\Phi$4) abhängige Amplitude (U4) aufweist, insb. derart, daß das zweite Magnetfeldsignal ($\phi$2) auf zumindest eine Änderung des vierten magnetischen Flusses ($\Phi$4) und/oder dessen Flächendichte (B4) mit einer Änderung der Amplitude (U4) folgt;
- und wobei die Meßsystem-Elektronik eingerichtet ist, auch das zweite Magnetfeldsignal ($\phi$2) zu empfangen und auszuwerten, nämlich anhand auch des zweiten Magnetfeldsignals zu ermitteln, ob das externe Magnetfeld (H1) vorliegt.

16. Vibronisches Meßsystem nach einem der vorherigen Ansprüche,

- wobei jede der ersten und zweiten Nutzkomponenten jeweils einen vom Massestrom abhängigen Phasenwinkel aufweist;
- und wobei die Meßsystem-Elektronik eingerichtet ist, die Massestrom-Meßwerte anhand einer Phasendifferenz zwischen den ersten und zweiten Nutzkomponenten, nämlich einer Differenz zwischen dem Phasenwinkel der ersten Nutzkomponente und dem Phasenwinkel der zweiten Nutzkomponente zu berechnen.

17. Vibronisches Meßsystem nach einem der vorherigen Ansprüche, wobei das wenigstens eine Vibrationselement mittels wenigstens eines, insb. zumindest abschnittsweise geraden und/oder zumindest abschnittsweise kreisbogenförmigen, Rohrs mit einem von einer, insb. metallischen, Rohrwand und einem davon umhüllten Lumen gebildet und dafür eingerichtet ist, von Meßstoff durchströmt und währenddessen vibrieren gelassen zu werden.

18. Verwenden eines vibronischen Meßsystems gemäß einem der vorherigen Ansprüche zum Messen eines Massestroms eines, insb. in einer Rohrleitung strömenden, fluiden Meßstoffs, insb. eines Gases, einer Flüssigkeit oder einer Dispersion.

**Claims**

1. A vibronic measuring system, in particular a Coriolis mass flow meter or a Coriolis mass flow/density meter, for measuring a mass flow of a fluid medium - in particular a gas, a liquid or a dispersion - said measuring system comprising:

   - A sensor (MW)

      -- which has at least one vibrating element (10), in particular a tubular one, for generating and maintaining mechanical vibrations of the at least one vibrating element (11), at least one vibration generator, and an electrodynamic first vibration sensor (51), and at least one electrodynamic second vibration sensor (52), in particular one with an identical design to that of the first vibration sensor (51), for registering mechanical vibrations of the at least one vibrating element, in particular its useful vibrations, and
      -- which is configured to conduct the medium, namely to have the medium flow through it at least occasionally;

   - A sensor housing (100) for the sensor, in particular with a wall made from a metal;
   - At least a first magnetic field detector (61), in particular one formed by a Hall sensor and/or a Reed switch, for registering a magnetic field (H0+H1) established inside the measuring system, in particular namely caused by an electrical field generated outside the sensor housing and/or a magnet positioned outside the sensor housing and/or a time-constant magnetic field;
   - And measuring system electronics (ME) which are electrically coupled with the sensor, namely electrically coupled with its at least one vibration generator and its first and second vibration sensors, as well as the first magnetic field detector (61), and which are in particular formed by at least one microprocessor and/or have a modular design;
   - wherein the sensor is positioned inside the sensor housing (100) and the first magnetic field detector is positioned outside the sensor housing (100), in particular in such a way that the at least one vibrating element (11) is held on the sensor housing (100) and/or that the first magnetic field detector is attached to the outside of the sensor housing (100);
   - wherein the at least one vibrating element is configured to be contacted by the flowing medium, causing it to vibrate in the process;
   - wherein the at least one vibration generator is configured to convert the electrical energy fed to it into mechanical power, which causes mechanical vibrations of the vibrating element;
   - wherein the measuring system electronics are configured to generate an electrical driver signal (e1) and therefore to feed electrical power to the at least one vibration generator in such a way that the vibrating element carries out useful vibrations at least proportionally, namely forced mechanical vibrations at at least one useful frequency, namely at a vibration frequency prespecified by the electrical driver signal, in particular at a resonance frequency of the sensor, which are suitable for effecting Coriolis forces dependent on the mass flow in the flowing medium;
   -- wherein the first vibration sensor (51) is configured to convert vibrating movements of the at least one vibrating element at a first measuring point into an electrical first vibration measuring signal (s1) of the sensor in such a way that said first vibration measuring signal has at least a first useful component ($s1_{N1}$), namely an alternating frequency component

      -- with a frequency corresponding to the useful frequency,
      -- and with an amplitude ($U1_N$) which depends on the useful frequency and a first magnetic flux ($\Phi1$), namely a magnetic flux through the first vibration sensor (51);

   - wherein the second vibration sensor (52) is configured to convert vibrating movements of the at least one vibrating element at a second measuring point positioned away from the first measuring point into an electrical second vibration measuring signal of the sensor in such a way that said second vibration measuring signal has at least a second useful component ($s2_{N1}$), namely an alternating frequency component

      -- with a frequency corresponding to the useful frequency,
      -- and with an amplitude which depends on the useful frequency and a second magnetic flux ($\Phi2$), namely a magnetic flux through the second vibration sensor (52);

   - wherein the first magnetic field detector (61) is configured to register the magnetic field (H1) at a third measuring point located outside the sensor housing (100) and to convert it into a first magnetic field signal ($\Phi1$), in particular

a magnetic field signal which evaluates and/or quantifies said magnetic field (H1) and/or which is electrical, said first magnetic field signal having an amplitude (U3) which depends on a third magnetic flux ($\Phi$3), namely a magnetic flux through the first magnetic field detector and/or on a surface density (B3) of said magnetic flux ($\Phi$3), in particular in such a way that the first magnetic field signal follows at least one change to the third magnetic flux ($\Phi$3) and/or its surface density (B3) with a change to the amplitude (U3);
- and wherein the measuring system electronics (20) are configured to receive and evaluate both the first and second vibration measuring signals as well as at least the first magnetic field signal ($\Phi$1), namely

-- to determine, using the first and second vibration measuring signals, mass flow measured values, in particular digital ones, which represent the mass flow, in particular namely to output these at a signal output
-- and to at least qualitatively determine, using the first magnetic field signal, whether and/or to what extent the magnetic field (H1) has been established at the first and/or second measuring points and contributes toward the first and/or second magnetic fluxes ($\Phi$1, $\Phi$2), and/or to determine whether there is a measuring system malfunction due to said magnetic field (H1), in particular one which impairs the functionality of the measuring system and/or causes a measuring system malfunction and/or reduces an integrity of at least one of the first and second vibration measuring signals or the mass flow measured values derived therefrom.

2. The vibronic measuring system as claimed in claim 1, further comprising: At least one electronics housing (200), in particular one with a modular design, wherein the measuring system electronics are at least partly, in particular completely, housed inside the electronics housing (200) and/or wherein the first magnetic field detector is positioned outside the electronics housing (200).

3. The vibronic measuring system as claimed in the preceding claim, wherein the sensor housing (100) has a connecting piece for the electronics housing (200), and wherein the electronics housing (200) is mechanically connected to the connecting piece, in particular in such a way that it can be separated again.

4. The vibronic measuring system as claimed in one of the preceding claims, further comprising: a protective screen, in particular a metallic one, for the at least one magnetic field detector, wherein the protective screen is positioned outside the sensor housing to form a space located between the protective screen and sensor housing, in particular namely attached to the outside of the sensor housing, and wherein the magnetic field detector is positioned inside said space.

5. The vibronic measuring system as claimed in the preceding claim,

- wherein the protective screen is at least partly made from a stainless steel; and/or
- wherein the protective screen is materially bonded to the sensor housing, in particular namely welded to it; and/or
- wherein the protective screen is secured to the sensor housing by means of at least one seal.

6. The vibronic measuring system as claimed in one of claims 2 to 5, wherein the electronics housing (200) is modularly designed in such a way that the electronics housing (200) has a first housing module (200A) and a second housing module (200B), in particular in such a way that the first housing module (200A) is attached to the outside of the sensor housing (100) and/or that the second housing module (200B) is attached to the outside of the first housing module (200A).

7. The vibronic measuring system as claimed in one of the preceding claims, wherein the measuring system electronics are modularly designed in such a way that the measuring system electronics have a first electronic module (ME1) and a second electronic module (ME2).

8. The vibronic measuring system as claimed in claims 6 and 7,

- wherein the first housing module (200A) of the electronics housing (200) is configured to house the first electronic module (ME1) of the measuring system electronics (ME), and the second housing module (200B) of the electronics housing (200) is configured to house the second electronic module (ME2) of the measuring system electronics (ME);
- and wherein the first electronic module (ME1) is housed inside the first housing module (200A) and the second electronic module (ME2) is housed inside the second housing module (200B).

9. The vibronic measuring system as claimed in claim 7 or 8,

- wherein the first electronic module (ME1) of the measuring system electronics is configured to generate the driver signal as well as to receive and evaluate the first and second vibration measuring signals, and the second electronic module (ME2) of the measuring system electronics is configured to receive and evaluate the first magnetic field signal; and/or
- wherein the first and second electronic modules (ME1, ME2) of the measuring system electronics are electrically coupled with each other, in particular in such a way that a signal output of the first electronic module (ME1) is electrically connected to a signal input of the second electronic module (ME2).

10. The vibronic measuring system as claimed in one of the preceding claims, wherein the first magnetic field signal ($\Phi 1$) is an analog signal, in particular a continuous-value and continuous-time analog signal, in particular one which has a voltage dependent on the third magnet flux ($\Phi 3$) and/or its surface density (B3).

11. The vibronic measuring system as claimed in the preceding claim, wherein the measuring system electronics are configured to calculate key values for at least one magnetic field figure (MK1) using the first magnetic field signal, in particular a magnetic field figure which characterizes an impact on the sensor due the external magnetic field and/or an impact on at least one of the first and second magnetic fluxes, in particular in such a way that said magnetic field figure is dependent on a deviation of the first magnetic flux from the second magnetic flux and/or evaluates and/or quantifies said deviation, or in such a way that said magnetic field figure is dependent on a deviation of the first magnetic flux from a reference value determined in advance and/or evaluates and/or quantifies said deviation.

12. The vibronic measuring system as claimed in one of the preceding claims,

- wherein the measuring system electronics have a non-volatile electronic memory (EEPROM) which is configured for storing digital data, in particular also when no operating voltage is present, in particular to store namely one or more reference values for the magnetic field figure which have been determined in advance;
- and wherein reference values for the magnetic field figure, in particular reference values which have been determined in advance by the manufacturer of the measuring system and/or during manufacture of the measuring system and/or during operation of the measuring system, are saved in the electronic memory, in particular namely one or more reference values indicative of impaired functionality of the sensor and/or namely one or more reference values indicative of a sensor malfunction.

13. The vibronic measuring system as claimed in the preceding claim, wherein the measuring system electronics are configured to compare one or more key values for the magnetic field figure with one or more reference values for the magnetic field figure saved in the memory.

14. The vibronic measuring system as claimed in one of the preceding claims, wherein the first magnetic field detector is closer to the first vibration sensor (51) than it is to the second vibration sensor (52) and/or is positioned less than 5 cm away from the first vibration sensor (51).

15. The vibronic measuring system as claimed in one of the preceding claims, further comprising: At least a second magnetic field detector (62), in particular one formed by a Hall sensor and/or a Reed switch and/or with an identical design to that of the first magnetic field detector (61), for registering the magnetic field (H1),

- wherein the second magnetic field detector (62) is configured to register the magnetic field (H1) at a fourth measuring point located at a distance from the third measuring point, in particular also at a distance from the first measuring point and/or from the second measuring point and/or positioned outside the sensor housing (100), and to convert it into a second magnetic field signal ($\Phi 2$), in particular a magnetic field signal which evaluates and/or quantifies the magnetic field (H1) and/or which is electrical, said second magnetic field signal having an amplitude (U4) which depends on a fourth magnetic flux ($\Phi 4$), namely a magnetic flux through the second magnetic field detector and/or on a surface density (B4) of said magnetic flux ($\Phi 4$), in particular in such a way that the second magnetic field signal ($\phi 2$) follows at least one change to the fourth magnetic flux ($\Phi 4$) and/or its surface density (B4) with a change to the amplitude (U4);
- and wherein the measuring system electronics are configured to also receive and evaluate the second magnetic field signal ($\Phi 2$), namely to determine, also using the second magnetic field signal, whether the external magnetic field (H1) is present.

16. The vibronic measuring system as claimed in one of the preceding claims,

- wherein each of the first and second useful components has a phase angle which depends on the mass flow;
- and wherein the measuring system electronics are configured to calculate the mass flow measured values using a phase difference between the first and second useful components, namely a difference between the phase angle of the first useful component and the phase angle of the second useful component.

**17.** The vibronic measuring system as claimed in one of the preceding claims, wherein the at least one vibrating element is formed by at least one pipe, in particular one which has at least some straight sections and/or at least some curved sections, with a pipe wall, in particular a metallic pipe wall, and a lumen enclosed by said wall, and is configured for the medium to flow through it, causing said vibrating element to vibrate.

**18.** A use of a vibronic measuring system as claimed in one of the preceding claims for measuring a mass flow of a fluid medium, in particular one flowing in a pipeline, in particular a gas, a liquid or a dispersion.


**Revendications**

**1.** Système de mesure vibronique, notamment un débitmètre massique Coriolis ou un débitmètre massique/densimètre Coriolis, lequel système est destiné à mesurer un débit massique d'un produit fluide - notamment d'un gaz, d'un liquide ou d'une dispersion -, lequel système de mesure comprend :

- un transducteur (MW),

-- lequel transducteur présente au moins un élément vibrant (10), notamment tubulaire, au moins un excitateur de vibrations destiné à exciter et maintenir des vibrations mécaniques de l'au moins un élément vibrant (11), ainsi qu'un premier capteur de vibrations électrodynamique (51) et au moins un deuxième capteur de vibrations électrodynamique (52), notamment de construction identique au premier capteur de vibrations (51), lesquels capteurs sont destinés à détecter des vibrations mécaniques de l'au moins un élément vibrant, notamment ses vibrations utiles, et
-- lequel transducteur est conçu pour guider le produit, notamment pour être traversé au moins temporairement par le produit ;

- un boîtier de transmetteur (100) pour loger le transmetteur, lequel boîtier est notamment doté d'une paroi métallique ;
- au moins un premier détecteur de champ magnétique (61) formé notamment au moyen d'un capteur à effet Hall et/ou d'un interrupteur à lames souples, lequel détecteur est destiné à détecter un champ magnétique (H0+H1) établi à l'intérieur du système de mesure, notamment provoqué par un champ électrique généré à l'extérieur du boîtier de transducteur et/ou par un aimant positionné à l'extérieur du boîtier de transducteur et/ou constant dans le temps ;
- ainsi qu'une électronique de système de mesure (ME) couplée électriquement aussi bien au transducteur - à savoir à son au moins un excitateur de vibrations et à ses premier et deuxième capteurs de vibrations - qu'au premier détecteur de champ magnétique (61), laquelle électronique est notamment formée et/ou conçue de façon modulaire au moyen d'au moins un microprocesseur ;
- le transducteur étant positionné à l'intérieur du boîtier de transducteur (100) et le premier détecteur de champ magnétique étant positionné à l'extérieur du boîtier de transducteur (100), notamment de telle sorte que l'au moins un élément vibrant (11) est maintenu sur le boîtier de transducteur (100) et/ou que le premier détecteur de champ magnétique est monté à l'extérieur du boîtier de transducteur (100) ;
- l'au moins un élément vibrant étant conçu pour être mis en contact avec le produit qui s'écoule et pour être laissé vibrer pendant ce temps ;
- l'au moins un excitateur de vibrations étant conçu pour convertir l'énergie électrique qui lui est fournie en une énergie mécanique provoquant des vibrations mécaniques forcées de l'élément vibrant ;
- l'électronique de système de mesure étant conçue pour générer un signal d'attaque électrique (e1) et pour alimenter ainsi en énergie électrique l'au moins un excitateur de vibrations, de telle sorte que l'élément vibrant exécute au moins en partie des vibrations utiles, à savoir des vibrations mécaniques forcées avec au moins une fréquence utile, à savoir une fréquence de vibration prédéfinie par le signal d'attaque électrique, laquelle fréquence correspond notamment à une fréquence de résonance du transducteur, lesquelles vibrations sont appropriées pour provoquer dans le produit en écoulement des forces de Coriolis dépendant du débit massique ;
- le premier capteur de vibrations (51) étant conçu pour convertir les mouvements vibratoires de l'au moins un élément vibrant au niveau d'un premier point de mesure, en un premier signal électrique de mesure de vibration (s1) du transducteur, de telle sorte que ledit premier signal de mesure de vibration comprenne au moins une première composante utile ($s1_{N1}$), à savoir une composante de tension alternative

-- avec une fréquence correspondant à la fréquence utile,
-- et avec une amplitude ($U1_N$) dépendant de la fréquence utile et d'un premier flux magnétique ($\Phi1$), à savoir un flux magnétique à travers le premier capteur de vibrations (51) ;

- le deuxième capteur de vibrations (52) étant conçu pour convertir les mouvements vibratoires de l'au moins un élément vibrant au niveau d'un deuxième point de mesure distant du premier point de mesure, en un deuxième signal électrique de mesure de vibration (s2) du transducteur, de telle sorte que ledit deuxième signal de mesure de vibration comprenne au moins une deuxième composante utile ($s2_{N1}$), à savoir une composante de tension alternative

-- avec une fréquence correspondant à la fréquence utile,
-- et avec une amplitude ($U2_N$) dépendant de la fréquence utile et d'un deuxième flux magnétique ($\Phi2$), à savoir un flux magnétique à travers le deuxième capteur de vibrations (52) ;

- le premier détecteur de champ magnétique (61) étant conçu pour détecter le champ magnétique (H1) au niveau d'un troisième point de mesure situé à l'extérieur du boîtier de transducteur (100) et pour le convertir en un premier signal de champ magnétique ($\phi1$), lequel signal évalue et/ou quantifie le même champ magnétique (H1) et/ou est électrique, lequel signal présente une amplitude qui dépend d'un troisième flux magnétique ($\Phi3$), à savoir un flux magnétique à travers le premier détecteur de champ magnétique et/ou une densité de surface (B3) du flux magnétique ($\Phi3$) en question, notamment de telle sorte que le premier signal de champ magnétique suit au moins une modification du troisième flux magnétique ($\Phi3$) et/ou de sa densité de surface (B3) avec une modification de l'amplitude (U3) ;
- et l'électronique de système de mesure (20) étant conçue pour recevoir et évaluer aussi bien les premiers et deuxièmes signaux de mesure de vibration qu'au moins le premier signal de champ magnétique ($\phi1$), à savoir

-- pour déterminer, à l'aide des premiers et des deuxièmes signaux de mesure de vibration, des valeurs mesurées de débit massique, notamment numériques, représentant le débit massique, notamment pour délivrer lesdits signaux à une sortie de signal,
-- ainsi que pour déterminer, à l'aide du premier signal de champ magnétique, au moins qualitativement, si et/ou dans quelle mesure le champ magnétique (H1) est établi aux premiers et/ou aux deuxièmes points de mesure ou apporte une contribution aux premiers et/ou aux deuxièmes flux magnétiques ($\Phi1$, $\Phi2$), et/ou pour déterminer si une perturbation - notamment une diminution de la capacité de fonctionnement du système de mesure et/ou un dysfonctionnement du système de mesure et/ou une dégradation de l'intégrité d'au moins l'un des premiers et des deuxièmes signaux de mesure de vibration ou des valeurs mesurées de débit massique obtenues à partir desdits signaux - du système de mesure par ledit champ magnétique (H1) est présente.

2. Système de mesure vibronique selon la revendication 1, comprenant en outre au moins un boîtier électronique (200), notamment de construction modulaire, l'électronique du système de mesure étant logée au moins partiellement, notamment complètement, à l'intérieur du boîtier électronique (200) et/ou le premier détecteur de champ magnétique étant positionné à l'extérieur du boîtier électronique (200).

3. Système de mesure vibronique selon la revendication précédente, pour lequel le boîtier de transmetteur (100) présente une tubulure de raccordement pour le boîtier électronique (200), le boîtier électronique (200) étant relié mécaniquement à la tubulure de raccordement, notamment de manière amovible.

4. Système de mesure vibronique selon l'une des revendications précédentes, comprenant en outre : un écran de protection, notamment métallique, pour l'au moins un détecteur de champ magnétique, l'écran de protection étant positionné à l'extérieur du boîtier de transmetteur en formant un espace intermédiaire situé entre l'écran de protection et le boîtier de transmetteur, notamment monté à l'extérieur du boîtier de transmetteur, et le détecteur de champ magnétique étant positionné à l'intérieur du même espace intermédiaire.

5. Système de mesure vibronique selon la revendication précédente,

- pour lequel l'écran de protection est constitué au moins partiellement d'un acier inoxydable ; et/ou

- pour lequel l'écran de protection est relié au boîtier de transmetteur par une liaison de matière, notamment soudé à celui-ci ; et/ou
- pour lequel l'écran de protection est fixé au boîtier de transmetteur au moyen d'au moins un plombage.

6. Système de mesure vibronique selon l'une des revendications 2 à 5, pour lequel le boîtier électronique (200) est conçu de manière modulaire, de telle sorte que le boîtier électronique (200) comporte un premier module de boîtier (200A) et un deuxième module de boîtier (200B), notamment de telle sorte que le premier module de boîtier (200A) est monté à l'extérieur du boîtier de transmetteur (100) et/ou que le deuxième module de boîtier (200B) est monté à l'extérieur du premier module de boîtier (200A).

7. Système de mesure vibronique selon l'une des revendications précédentes, pour lequel l'électronique de système de mesure est conçue de manière modulaire, de telle sorte que l'électronique de système de mesure présente un premier module électronique (ME1) et un deuxième module électronique (ME2).

8. Système de mesure vibronique selon la revendication 6 et 7,

- pour lequel le premier module de boîtier (200A) du boîtier électronique (200) est conçu pour recevoir le premier module électronique (ME1) de l'électronique de système de mesure (ME), et le deuxième module de boîtier (200B) du boîtier électronique (200) est conçu pour recevoir le deuxième module électronique (ME2) de l'électronique de système de mesure (ME) ;
- et pour lequel le premier module électronique (ME1) est logé à l'intérieur du premier module de boîtier (200A) et le deuxième module électronique (ME2) est logé à l'intérieur du deuxième module de boîtier (200B).

9. Système de mesure vibronique selon la revendication 7 ou 8,

- pour lequel le premier module électronique (ME1) de l'électronique du système de mesure est conçu pour générer le signal d'attaque ainsi que pour recevoir et évaluer les premier et deuxième signaux de mesure des vibrations, et
pour lequel le deuxième module électronique (ME2) de l'électronique du système de mesure est conçu pour recevoir et évaluer le premier signal de champ magnétique ; et/ou
- les premier et deuxième modules électroniques (ME1, ME2) de l'électronique du système de mesure étant couplés électriquement entre eux, notamment de telle sorte qu'une sortie de signal du premier module électronique (ME1) est reliée électriquement à une entrée de signal du deuxième module électronique (ME2).

10. Système de mesure vibronique selon l'une des revendications précédentes, pour lequel le premier signal de champ magnétique ($\phi1$) est un signal analogique, notamment à valeur et à temps continus, notamment avec une tension dépendant du troisième flux magnétique ($\Phi3$) et/ou de sa densité de surface (B3).

11. Système de mesure vibronique selon la revendication précédente, pour lequel l'électronique de système de mesure est conçue pour calculer, à l'aide du premier signal de champ magnétique, des valeurs caractéristiques pour au moins un indice de champ magnétique (MK1), lesquelles valeurs caractérisent notamment une influence du capteur par le champ magnétique externe et/ou une influence d'au moins l'un des premier et deuxième flux magnétiques, notamment de telle sorte que ledit indice de champ magnétique dépend d'un écart du premier flux magnétique par rapport au deuxième flux magnétique et/ou évalue et/ou quantifie ledit écart ou que ledit indice de champ magnétique dépend d'un écart du premier flux magnétique par rapport à une valeur de référence déterminée au préalable et/ou évalue et/ou quantifie ledit écart.

12. Système de mesure vibronique selon l'une des revendications précédentes,

- pour lequel l'électronique de système de mesure comprend une mémoire de données électronique non volatile (EEPROM), laquelle est conçue pour conserver des données numériques, notamment même sans tension de service appliquée, à savoir pour enregistrer une ou plusieurs valeurs de référence déterminées au préalable pour l'indice de champ magnétique ;
- et pour lequel une ou plusieurs valeurs de référence pour l'indice de champ magnétique, notamment déterminées au préalable par le fabricant du système de mesure et/ou lors de la fabrication du système de mesure et/ou pendant le fonctionnement du système de mesure, notamment une ou plusieurs valeurs de référence représentant une capacité de fonctionnement réduite du capteur et/ou notamment une ou plusieurs valeurs de référence représentant un dysfonctionnement du capteur, sont mémorisées dans la mémoire de données électronique.

13. Système de mesure vibronique selon la revendication précédente, pour lequel l'électronique du système de mesure est conçue pour comparer une ou plusieurs valeurs caractéristiques pour l'indice de champ magnétique respectivement avec une ou plusieurs valeurs de référence pour l'indice de champ magnétique stockées dans la mémoire de données.

14. Système de mesure vibronique selon l'une des revendications précédentes, pour lequel le premier détecteur de champ magnétique est positionné moins loin du premier capteur de vibrations (51) que du deuxième capteur de vibrations (52) et/ou à moins de 5 cm du premier capteur de vibrations (51).

15. Système de mesure vibronique selon l'une des revendications précédentes, comprenant en outre : pour la détection du champ magnétique (H1), au moins un deuxième détecteur de champ magnétique (62), formé notamment au moyen d'un capteur à effet Hall et/ou d'un interrupteur à lames souples et/ou de construction identique au premier détecteur de champ magnétique (61),

- le deuxième détecteur de champ magnétique (62) étant conçu pour détecter le champ magnétique (H1) au niveau d'un quatrième point de mesure éloigné du troisième point de mesure, notamment également éloigné du premier point de mesure et/ou du deuxième point de mesure et/ou situé à l'extérieur du boîtier de transmetteur (100), et pour le convertir en un deuxième signal de champ magnétique ($\phi 2$), notamment évaluant le champ magnétique (H1) et/ou quantifiant le champ magnétique (H1) et/ou électrique, lequel signal présente une amplitude (U4) dépendant d'un quatrième flux magnétique ($\Phi 4$), notamment un flux magnétique à travers le deuxième détecteur de champ magnétique et/ou dépendant d'une densité de surface (B4) dudit flux magnétique ($\Phi 4$), notamment de telle sorte que le deuxième signal de champ magnétique ($\phi 2$) suit au moins une modification du quatrième flux magnétique ($\Phi 4$) et/ou de sa densité de surface (B4) avec une modification de l'amplitude (U4) ;
- et l'électronique de système de mesure étant conçue pour recevoir et évaluer également le deuxième signal de champ magnétique ($\phi 2$), à savoir déterminer à l'aide du deuxième signal de champ magnétique si le champ magnétique externe (H1) est présent.

16. Système de mesure vibronique selon l'une des revendications précédentes,

- pour lequel chacune des première et deuxième composantes utiles présente respectivement un angle de phase dépendant du débit massique ;
- et pour lequel l'électronique du système de mesure est conçue pour calculer les valeurs mesurées de débit massique à l'aide d'une différence de phase entre les première et deuxième composantes utiles, à savoir une différence entre l'angle de phase de la première composante utile et l'angle de phase de la deuxième composante utile.

17. Système de mesure vibronique selon l'une des revendications précédentes, pour lequel l'au moins un élément vibrant est formé au moyen d'au moins un tube, notamment au moins partiellement droit et/ou au moins partiellement en forme d'arc de cercle, avec un canal intérieur enveloppé par une paroi de tube, notamment métallique, et un canal intérieur enveloppé par ladite paroi, et lequel élément est conçu pour être traversé par un produit et être laissé vibrer pendant ce temps.

18. Utilisation d'un système de mesure vibronique selon l'une des revendications précédentes, lequel système est destiné à la mesure d'un débit massique d'un produit fluide, notamment d'un gaz, d'un liquide ou d'une dispersion, s'écoulant dans une conduite.

Fig. 1

Fig. 2

**Fig. 3**

Fig. 4a

Fig. 4b

**Fig. 5a**

**Fig. 5b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 564682 A
- EP 816807 A
- EP 644403 A
- US 20020033043 A
- US 20060096390 A
- US 20070062309 A
- US 20070119264 A
- US 20080011101 A
- US 20080047362 A
- US 20080190195 A
- US 20080250871 A
- US 20100005887 A
- US 20100011882 A
- US 20100257943 A
- US 20110161017 A
- US 20110178738 A
- US 20110219872 A
- US 20110265580 A
- US 20110271756 A
- US 20120123705 A
- US 20130042700 A
- US 20160071639 A
- US 20160313162 A
- US 20160187176 A
- US 20170003156 A
- US 20170261474 A
- US 4491009 A
- US 4756198 A
- US 4777833 A
- US 4801897 A
- US 4876898 A
- US 4996871 A
- US 5009109 A
- US 5287754 A
- US 5291792 A
- US 5349872 A
- US 5705754 A
- US 5796010 A
- US 5796011 A
- US 5804742 A
- US 5831178 A
- US 5945609 A
- US 5965824 A
- US 6006609 A
- US 6092429 A
- US 6223605 B
- US 6311136 B
- US 6477901 B
- US 6505518 B
- US 6513393 B
- US 6651513 B
- US 6666098 B
- US 6711958 B
- US 6840109 B
- US 6883387 B
- US 6920798 B
- US 7017424 B
- US 7040181 B
- US 7077014 B
- US 7143655 B
- US 7200503 B
- US 7216549 B
- US 7296484 B
- US 7325462 B
- US 7360451 B
- US 7665369 B
- US 7792646 B
- US 7954388 B
- US 8201460 B
- US 8333120 B
- US 8695436 B
- WO 0019175 A
- WO 0034748 A
- WO 0102812 A
- WO 0102816 A
- WO 0171291 A
- WO 02060805 A
- WO 2005050145 A
- WO 2005093381 A
- WO 2007043996 A
- WO 2008013545 A
- WO 2008059262 A
- WO 2009148451 A
- WO 2010099276 A
- WO 2013092104 A
- WO 2014151829 A
- WO 2016058745 A
- WO 2017069749 A
- WO 2017123214 A
- WO 2017137347 A
- WO 2017143579 A
- WO 2018160382 A
- WO 2018174841 A
- WO 8505677 A
- WO 8802853 A
- WO 8803642 A
- WO 8900679 A
- WO 9421999 A

- WO 9503528 A
- WO 9516897 A
- WO 9529385 A
- WO 9529386 A
- WO 9802725 A
- WO 9940394 A

- WO 2018028932 A
- WO 2018007176 A
- WO 2018007185 A
- WO 2019068553 A
- US 5531126 A
- EP 2017067826 W